# EUROPEAN PATENT APPLICATION

(11) **EP 3 876 281 A1**
(43) Date of publication of application: **08.09.2021**
(21) Application number: 19878906.7
(22) Date of filing: 01.11.2019
(51) Int. Cl.: H01L 27/15, H01L 33/24, H01L 33/38, H01L 33/62

(54) **LIGHT EMITTING ELEMENT**

(30) Priority: 02.11.2018 US 201862754721 P; 29.10.2019 US 201916666626
(71) Applicant: Seoul Viosys Co., Ltd, Ansan-si, Gyeonggi-do 15429 (KR)
(72) Inventor: CHAE, Jong Hyeon, Ansan-si Gyeonggi-do 15429 (KR); SHIN, Chan Seob, Ansan-si Gyeonggi-do 15429 (KR); LEE, Seom Geun, Ansan-si Gyeonggi-do 15429 (KR); LEE, Ho Joon, Ansan-si Gyeonggi-do 15429 (KR); JANG, Seong Kyu, Ansan-si Gyeonggi-do 15429 (KR)
(74) Representative: Stolmár & Partner Patentanwälte PartG mbB
(86) International application number: PCT/KR2019/014688
(87) International publication number: WO 2020/091495

(57) **Abstract**

Provided is a light emitting element. The light emitting device comprises: a first light emitting unit having a first area; a second light emitting unit having a second area; and a third light emitting unit having a third area, wherein the first light emitting unit is coplanar with the second light emitting unit, and the third light emitting unit is disposed over the first and second light emitting units, and the third area is larger than each of the first and second areas.

## Description

### [Technical Field]

Exemplary embodiments of the present disclosure relate to a light emitting device, and more particularly, to a light emitting device in which a plurality of light emitting parts are stacked.

### [Background Art]

Light emitting diodes as inorganic light sources are being diversely used in various fields such as display devices, vehicle lamps and general lighting. Light emitting diodes are rapidly replacing existing light sources due to their longer lifetime, lower power consumption and quicker response speed than the existing light sources.

In general, a display device displays various colors by generally utilizing mixed colors of blue, green and red. Each pixel of a display device includes blue, green and red sub pixels, the color of a particular pixel is determined through the colors of these sub pixels, and an image is displayed by a combination of pixels.

Light emitting diodes have been mainly used as backlight sources in display devices. However, recently, a micro LED display has been developed as a next generation display which directly implements images by using light emitting diodes.

### [Disclosure]

### [Technical Problem]

Various embodiments are directed to a light emitting device which is improved in light efficiency and light extraction.

Objects to be achieved by the disclosure are not limited to the aforementioned objects, and those skilled in the art to which the disclosure pertains may clearly understand other objects from the following descriptions.

### [Technical Solution]

An exemplary embodiment of the present disclosure provides a light emitting device, including: a first light emitting part having a first area; a second light emitting part having a second area; and a third light emitting part having a third area, wherein the first light emitting part is positioned on the same plane as the second light emitting part, wherein the third light emitting part is disposed over the first and second light emitting parts, and wherein the third area is larger than each of the first and second areas.

According to embodiments, the first light emitting part may include a first first-conductivity type semiconductor layer, and a first semiconductor structure which includes a first active layer and a first second-conductivity type semiconductor layer disposed on the first first-conductivity type semiconductor layer; the second light emitting part may include the first first-conductivity type semiconductor layer, and a second semiconductor structure which is disposed on the first first-conductivity type semiconductor layer to be separated from the first semiconductor structure and includes a second active layer and a second second-conductivity type semiconductor layer; and the third light emitting part may be disposed to be separated from the first and second light emitting parts and may include a third first-conductivity type semiconductor layer, a third active layer and a third second-conductivity type semiconductor layer.

According to embodiments, the light emitting device may further include a first pad electrically coupled with the first second-conductivity type semiconductor layer; a second pad electrically coupled with the second second-conductivity type semiconductor layer; a third pad electrically coupled with the third second-conductivity type semiconductor layer; and a common pad electrically coupling in common the first first-conductivity type semiconductor layer and the third first-conductivity type semiconductor layer.

According to embodiments, the light emitting device may further include a first through electrode electrically coupling the first second-conductivity type semiconductor layer and the first pad; a second through electrode electrically coupling the second second-conductivity type semiconductor layer and the second pad; a third through electrode electrically coupling the third second-conductivity type semiconductor layer and the third pad; a fourth through electrode electrically coupling the first first-conductivity type semiconductor layer which is exposed between the first and second semiconductor structures and the common pad; and a fifth through electrode electrically coupling the third first-conductivity type semiconductor layer and the common pad.

According to embodiments, the light emitting device may further include a first through electrode electrically coupling the first second-conductivity type semiconductor layer and the first pad; a second through electrode electrically coupling the second second-conductivity type semiconductor layer and the second pad; a third through electrode electrically coupling the third second-conductivity type semiconductor layer and the third pad; and a fourth through electrode electrically coupling the first and third first-conductivity type semiconductor layers and the common pad, wherein the fourth through electrode passes through the third first-conductivity type semiconductor layer and is electrically connected to the first first-conductivity type semiconductor layer exposed between the first and second semiconductor structures.

According to embodiments, the light emitting device may further include an adhesion part filling between the first and second light emitting parts and the third light emitting part and between the first and second semiconductor structures, and bonding the first and second light emitting parts and the third light emitting part.

According to embodiments, the adhesion part may include a material which is transparent and has an insulation property.

According to embodiments, the light emitting device may further include a dielectric layer surrounding outer sidewalls of the first to fourth through patterns, wherein the fourth through pattern passes through the third light emitting part and the adhesion part, one surface of the fourth through pattern is brought into contact with the first first-conductivity type semiconductor layer which is exposed between the first and second semiconductor structures, and the other surface of the fourth through pattern is brought into contact with the common pad, and wherein the common pad is brought into electrical contact with the third first-conductivity type semiconductor layer.

According to embodiments, the third light emitting part may include a hole which exposes the third first-conductivity type semiconductor layer, and the hole may have a width smaller than a width of the first first-conductivity type semiconductor layer which is exposed between the first and second semiconductor structures, at a position corresponding to the first first-conductivity type semiconductor layer which is exposed between the first and second semiconductor structures.

According to embodiments, the hole may be disposed between third first-conductivity type semiconductor layer and the first first-conductivity type semiconductor layer, and the adhesion part may fill the hole; and the fourth through pattern may pass through the third first-conductivity type semiconductor layer and the adhesion part, one surface of the fourth through pattern may be brought into contact with the common pad, the other surface facing away from the one surface may be brought into contact with the first first-conductivity type semiconductor layer, and a sidewall of the fourth through pattern may be brought into contact with the third first-conductivity type semiconductor layer.

According to embodiments, the light emitting device may further include a dielectric layer filling the hole, wherein the hole is disposed between the common pad and the third first-conductivity type semiconductor layer, and wherein the fourth through pattern passes through the dielectric layer and the third first-conductivity type semiconductor layer, an upper sidewall of the fourth through pattern is brought into contact with the dielectric layer, a middle sidewall of the fourth through pattern is brought into contact with the third first-conductivity type semiconductor layer, a lower sidewall of the fourth through pattern is brought into contact with the bonding part, one surface of the fourth through pattern is brought into contact with the common pad, and the other surface facing away from the one surface is brought into contact with the first first-conductivity type semiconductor layer which is exposed between the first and second semiconductor structures.

According to embodiments, the adhesion part may include a material which is transparent and has an electrical conductivity.

According to embodiments, the third light emitting part may include a hole which exposes the third first-conductivity type semiconductor layer; and the hole may have a width smaller than a width of the first first-conductivity type semiconductor layer which is exposed between the first and second semiconductor structures, at a position corresponding to the first first-conductivity type semiconductor layer which is exposed between the first and second semiconductor structures.

According to embodiments, the hole may face the first first-conductivity type semiconductor layer which is exposed between the first and second semiconductor structures; and the adhesion part may extend into the hole and be brought into contact with the third first-conductivity type semiconductor layer, and may extend between the first and second semiconductor structures and be brought into contact with the first first-conductivity type semiconductor layer.

According to embodiments, the fourth through pattern may be brought into contact with at least portions of the third first-conductivity type semiconductor layer and the adhesion part.

According to embodiments, the fourth through pattern may pass through the third first-conductivity type semiconductor layer, and a sidewall of the fourth through pattern may be brought into contact with the third first-conductivity type semiconductor layer.

According to embodiments, the light emitting device may further include a dielectric layer filling the hole, wherein the hole is disposed between the common pad and the third first-conductivity type semiconductor layer, and wherein the fourth through pattern passes through the dielectric layer and passes through at least portions of the third first-conductivity type semiconductor layer and the adhesion part, and a portion of the fourth through pattern is brought into contact with the third first-conductivity type semiconductor layer.

According to embodiments, the light emitting device may further include a substrate on which the first and second light emitting parts are disposed to be separated from each other; and a bonding layer bonding the substrate and the first and second light emitting parts, and including a conductive material.

According to embodiments, the first light emitting part may include a first first-conductivity type semiconductor layer, a first active layer and a first second-conductivity type semiconductor layer; the second light emitting part may include a second first-conductivity type semiconductor layer, a second active layer and a second second-conductivity type semiconductor layer; and the third light emitting part may include a third first-conductivity type semiconductor layer, a third active layer and a third second-conductivity type semiconductor layer.

According to embodiments, the bonding layer may electrically couple the first first-conductivity type semiconductor layer and the second first-conductivity type semiconductor layer.

According to embodiments, the light emitting device may further include a first pad electrically coupled with the first second-conductivity type semiconductor layer; a second pad electrically coupled with the second second-conductivity type semiconductor layer; a third pad electrically coupled with the third second-conductivity type semiconductor layer; and a common pad electrically coupled with the bonding layer.

According to embodiments, the bonding layer may include a first bonding layer disposed between the first first-conductivity type semiconductor layer and the substrate; and a second bonding layer disposed between the second first-conductivity type semiconductor layer and the substrate, and each of the first and second bonding layers may be electrically coupled with the substrate.

According to embodiments, the light emitting device may further include a first pad electrically coupled with the first second-conductivity type semiconductor layer; a second pad electrically coupled with the second second-conductivity type semiconductor layer; a third pad electrically coupled with the third second-conductivity type semiconductor layer; and a common pad electrically coupled with the substrate.

The details of other embodiments are included in the detailed description and the drawings.

### [Advantageous Effects]

In the light emitting device in accordance with the embodiments of the disclosure, since a light emitting part which emits red light is formed to have a size larger than a light emitting part which emits blue light or green light, the light emitting efficiency of the light emitting part which emits red light may be increased.

### [Description of Drawings]

FIG. 1A is a representation of an example of a top view to assist in the explanation of a light emitting device in accordance with an embodiment of the disclosure.
FIGS. 1B, 1C and 1D are cross-sectional views taken along the line A-A' of FIG. 1A to assist in the explanation of light emitting devices in accordance with embodiments of the disclosure.
FIGS. 2A, 2B and 2C are representations of examples of top views to assist in the explanation of disposition structures of the first light emitting part and the second light emitting part of the light emitting device shown in FIG. 1A.
FIG. 3A is a representation of an example of a top view to assist in the explanation of a light emitting device in accordance with another embodiment of the disclosure.
FIG. 3B is a cross-sectional view taken along the line A-A' of FIG. 3A.
FIG. 4 is a representation of an example of a cross-sectional view to assist in the explanation of a light emitting device in accordance with another embodiment of the disclosure.
FIGS. 5A and 5B are representations of examples of cross-sectional views to assist in the explanation of light emitting devices in accordance with other embodiments of the disclosure.
FIG. 6 is a representation of an example of a cross-sectional view to assist in the explanation of a light emitting device in accordance with another embodiment of the disclosure.
FIG. 7 is a representation of an example of a cross-sectional view to assist in the explanation of a light emitting device in accordance with another embodiment of the disclosure.
FIGS. 8A and 8B are representations of examples of cross-sectional views to assist in the explanation of light emitting devices in accordance with other embodiments of the disclosure.
FIGS. 9A to 26A are representations of examples of top views to assist in the explanation of a method for manufacturing a light emitting device in accordance with an embodiment of the disclosure.
FIGS. 9B to 26B are cross-sectional views taken along the lines A-A' of FIGS. 9A to 26A.
FIGS. 27 and 28 are representations of examples of cross-sectional views to assist in the explanation of a method for manufacturing a light emitting device in accordance with another embodiment of the disclosure.
FIGS. 29 and 30 are representations of examples of cross-sectional views to assist in the explanation of a method for mounting light emitting devices to a mounting board in accordance with an embodiment of the disclosure.

### [Best Mode]

In order to understand the configuration and effect of the disclosure sufficiently, embodiments of the disclosure will be described with reference to the accompanying drawings. However, the disclosure is not limited to the embodiments set forth herein and may be implemented in various forms, and a variety of changes may be added.

As used in the embodiments of the disclosure, a technical term may be interpreted as a meaning conventionally known to those of ordinary skill in the art unless defined otherwise.

Hereinafter, a light emitting device will be described below with reference to the accompanying drawings through various examples of embodiments.

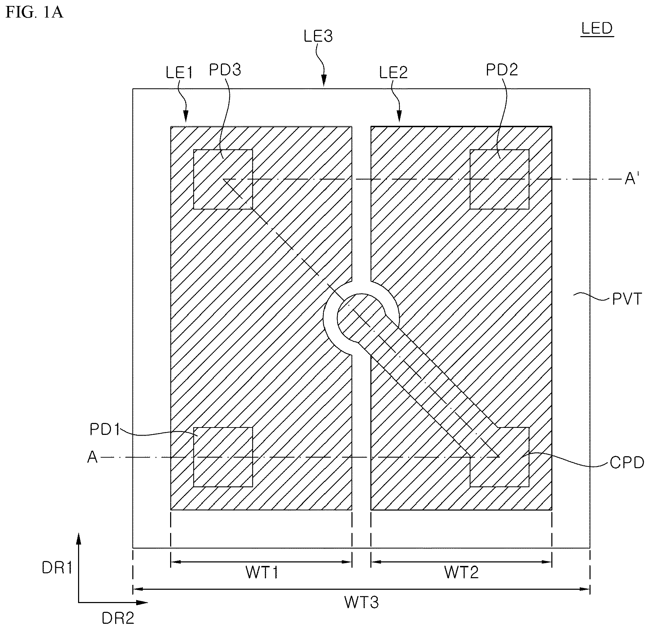

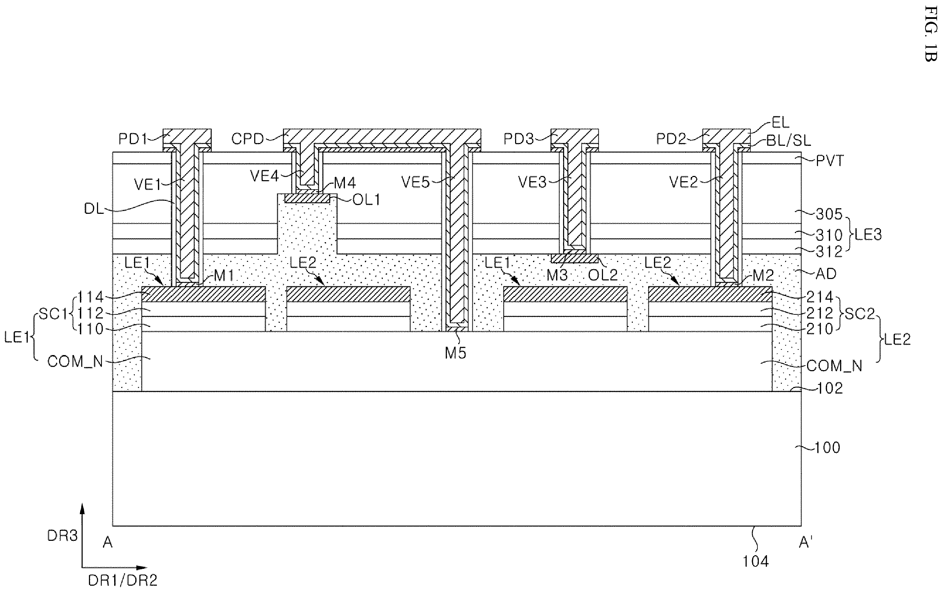

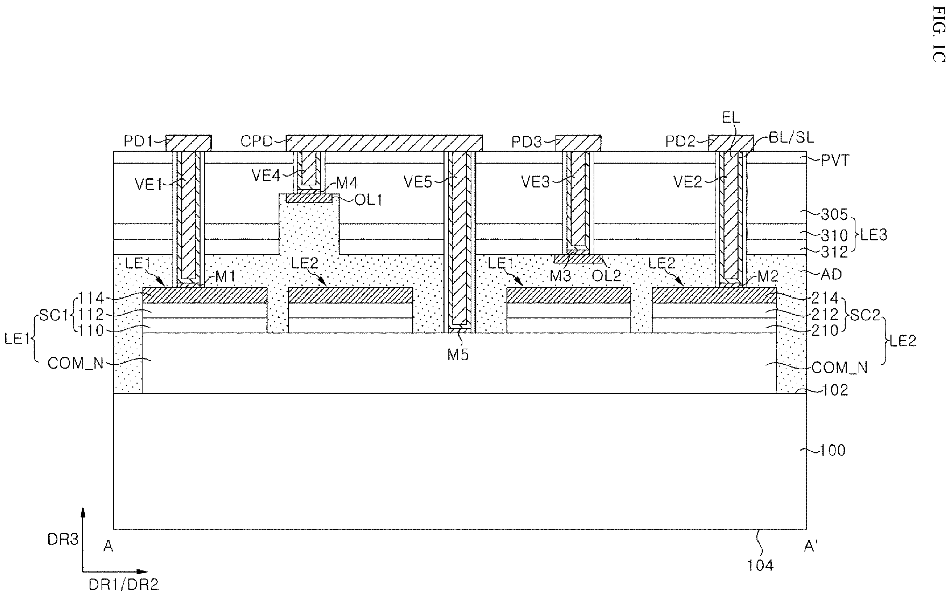

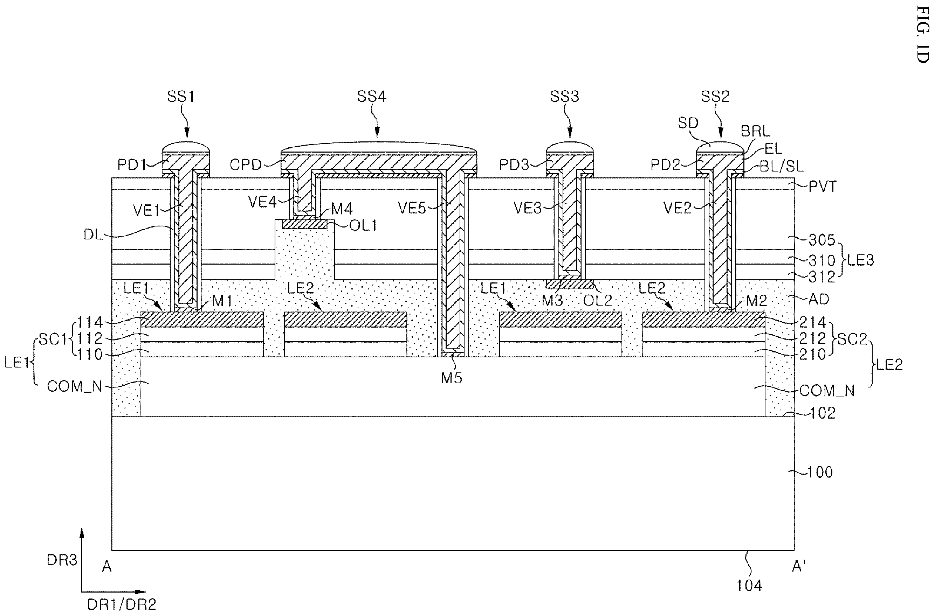

FIG. 1A is a representation of an example of a top view to assist in the explanation of a light emitting device in accordance with an embodiment of the disclosure, and FIGS. 1B, 1C and 1D are cross-sectional views taken along the line A-A' of FIG. 1A to assist in the explanation of light emitting devices in accordance with embodiments of the disclosure.

Referring to FIGS. 1A to ID, a light emitting device may include a substrate 100, and a first light emitting part LEI, a second light emitting part LE2 and a third light emitting part LE3 which are disposed on the substrate 100.

According to an embodiment, the first light emitting part LE1 and the second light emitting part LE2 may be disposed on a first surface 102 of the substrate 100 to be positioned on the same plane, and the third light emitting part LE3 may be disposed over the first light emitting part LE1 and the second light emitting part LE2. The size of the third light emitting part LE3 may be larger than the size of each of the first light emitting part LE1 and the second light emitting part LE2. The size of each of the light emitting parts LE1, LE2 and LE3 means an area through which light is emitted. For instance, the first light emitting part LE1 may have a first width WT1, the second light emitting part LE2 may have a second width WT2, and the third light emitting part LE3 may have a third width WT3. The third width WT3 may be larger than the first width WT1 and the second width WT2, and the first width WT1 and the second width WT2 may be the same with or different from each other.

In the case where a second surface 104 of the substrate 100 which faces away from the first surface 102 is a light extraction surface, the wavelength of the third light emitting part LE3 may be longest. For instance, the first light emitting part LE1 may emit blue light, the second light emitting part LE2 may emit green light, and the third light emitting part LE3 may emit red light. Unlike this, the first light emitting part LE1 may emit green light, the second light emitting part LE2 may emit blue light, and the third light emitting part LE3 may emit red light.

For example, in the case where the first light emitting part LE1 emits blue light, the second light emitting part LE2 emits green light and the third light emitting part LE3 emits red light, it is the norm that the third light emitting part LE3 which emits red light is lower in light emitting efficiency through the same area than the first light emitting part LE1 which emits blue light or the second light emitting part LE2 which emits green light. Therefore, as in the present embodiments, by forming the third light emitting part LE3 to have an area larger than each of the first light emitting part LE1 and the second light emitting part LE2, the same light emitting amount (light emitting efficiency) may be obtained when the same current is applied. Thus, the color balance of the light emitting device may be improved.

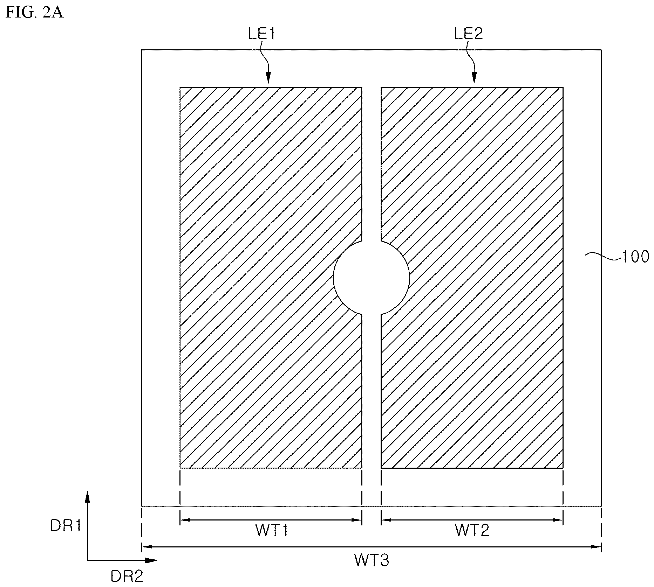

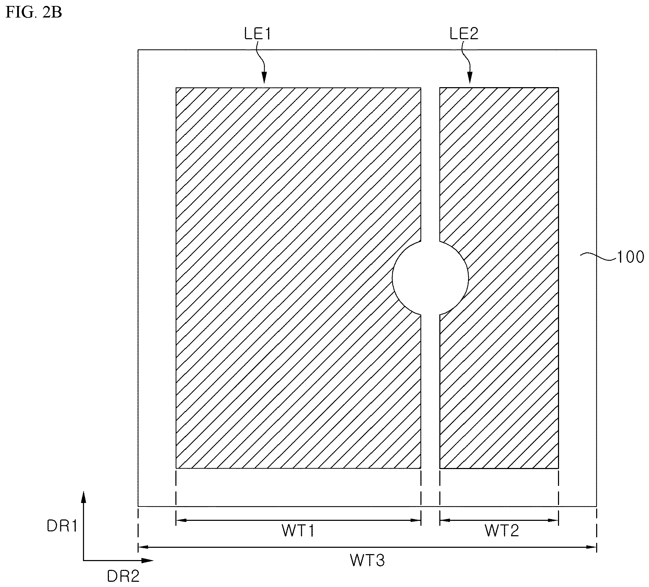

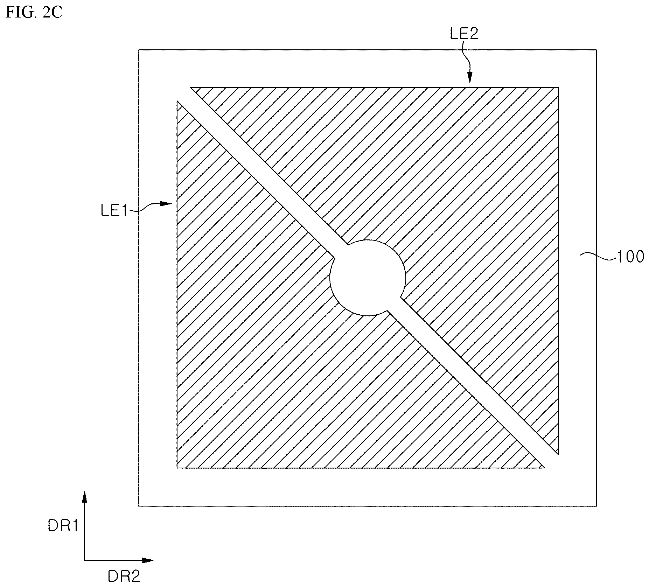

FIGS. 2A, 2B and 2C are representations of examples of top views to assist in the explanation of disposition structures of the first light emitting part and the second light emitting part of the light emitting device shown in FIG. 1A.

According to an example shown in FIG. 2A, when viewed from the top, the first light emitting part LE1 may be disposed on one side of the substrate 100 and may have a rectangular structure which has a long side extending in a first direction DR1, and the second light emitting part LE2 may be disposed on the other side of the substrate 100 to be separated from the first light emitting part LE1 in a second direction DR2 perpendicular to the first direction DR1 and may have a rectangular structure which has a long side extending in the first direction DR1. For instance, the first light emitting part LE1 may have a first width WT1, and the second light emitting part LE2 may have a second width WT2. The first width WT1 and the second width WT2 may be the same with or different from each other. The third light emitting part LE3 may be disposed to be separated from the first light emitting part LE1 and the second light emitting part LE2 in a third direction DR3 perpendicular to the first direction DR1 and the second direction DR2 and may have substantially the same structure as the substrate 100. The third light emitting part LE3 may have a third width WT3 larger than each of the first width WT1 and the second width WT2.

According to another example shown in FIG. 2B, in the case where the first light emitting part LE1 emits blue light and the second light emitting part LE2 emits green light, when viewed from the top, the size of the first light emitting part LE1 may be larger than the size of the second light emitting part LE2. The reason to this resides in that, because the visibility of green light is at least about six times more excellent than that of blue light, the first light emitting part LE1 which emits blue light is formed to have a size larger than the second light emitting part LE2 which emits green light, whereby the color balance of the light emitting device may be improved. For instance, when the first light emitting part LE1 has a first width WT1, the second light emitting part LE2 has a second width WT2 and the third light emitting part LE3 has a third width WT3, the first width WT1 may be larger than the second width WT2, and the third width WT3 may be larger than the first width WT1.

The present embodiment is described that the visibility of blue light is improved by enlarging the first light emitting part LE1 emitting blue light more than the second light emitting part LE2 emitting green light, but the present disclosure is not limited thereto. Since the first light emitting part LE1 emitting blue light has an external quantum efficiency higher than that of the second light emitting part LE2 emitting green light in general, it may be required to decrease luminous intensity of blue light. Further, it is needed to increase luminous intensity of green light higher than that of blue light in order to meet a proper color mixing ratio. Accordingly, it is required to adjust light emitting areas of the first light emitting part LE1 and the second light emitting part LE2 so that the first and second light emitting parts LE1 and LE2 may emit light of proper luminous intensity, and, in a case, the area of the first light emitting part LE1 may be smaller than that of the second light emitting part LE2.

According to still another example shown in FIG. 2C, when viewed from the top, the first light emitting part LE1 may be disposed on one part of the substrate 100 and may have a triangular structure, and the second light emitting part LE2 may be disposed on the other part of the substrate 100 by being separated from the first light emitting part LE1 and may have a triangular structure. The largest side of the first light emitting part LE1 and the largest side of the second light emitting part LE2 may face each other. The first light emitting part LE1 and the second light emitting part LE2 may have the same size or different sizes, and the third light emitting part LE3 may have a size larger than the first light emitting part LE1 and the second light emitting part LE2.

Referring again to FIGS. 1A and 1B, the first light emitting part LE1 may include a common n-type semiconductor layer COM_N, and a first semiconductor structure SC1 which includes a first active layer 110, a first p-type semiconductor layer 112 and a first transparent electrode layer 114 vertically stacked. The second light emitting part LE2 may include the common n-type semiconductor layer COM N, and a second semiconductor structure SC2 which includes a second active layer 210, a second p-type semiconductor layer 212 and a second transparent electrode layer 214 vertically stacked. The first semiconductor structure SC1 and the second semiconductor structure SC2 may be disposed on the common n-type semiconductor layer COM_N in such a way as to be separated from each other. That is to say, the common n-type semiconductor layer COM N may be exposed between the first semiconductor structure SC1 and the second semiconductor structure SC2.

The third light emitting part LE3 may include a third p-type semiconductor layer 312, a third active layer 310 and a third n-type semiconductor layer 305 which are vertically stacked. According to an embodiment, the third light emitting part LE3 may have a hole HL as the third p-type semiconductor layer 312 and the third active layer 310 are etched such that at least a portion of the third n-type semiconductor layer 305 is exposed. The third light emitting part LE3 may further include a first ohmic pattern OL1 which is brought into electrical contact with the third n-type semiconductor layer 305 exposed by the hole HL and a second ohmic pattern OL2 which is brought into electrical contact with the third p-type semiconductor layer 312.

According to an embodiment, the common n-type semiconductor layer may have a width smaller than the third light emitting part LE3. Meanwhile, the common n-type semiconductor layer COM_N and the third light emitting part LE3 may have substantially the same width.

Each of the common n-type semiconductor layer COM_N and the third n-type semiconductor layer 305 may be a Si-doped gallium nitride-based semiconductor layer. Each of the first p-type semiconductor layer 112, the second p-type semiconductor layer 212 and the third p-type semiconductor layer 312 may be a Mg-doped gallium nitride-based semiconductor layer. Each of the first active layer 110, the second active layer 210 and the third active layer 310 may include a multi-quantum well (MQW), and the composition ratio thereof may be determined to emit light of a desired peak wavelength. Each of the first transparent electrode layer 114 and the second transparent electrode layer 214 may include a transparent conductive oxide (TCO) such as ZnO, ITO (Indium Tin Oxide), ZITO (Zinc-doped Indium Tin Oxide), ZIO (Zinc Indium Oxide), GIO (Gallium Indium Oxide), ZTO (Zinc Tin Oxide), FTO (Fluorine-doped Tin Oxide), GZO (Gallium-doped Zinc Oxide), AZO (Aluminum-doped Zinc Oxide), or others.

Each of the first ohmic pattern OL1 and the second ohmic pattern OL2 may include a material which has a higher electrical conduction property than each of the first transparent electrode layer 114 and the second transparent electrode layer 214. Each of the first ohmic pattern OL1 and the second ohmic pattern OL2 may include at least one selected from the group consisting of Au, Ge and Be, or transparent conductive oxide (TCO). For example, the first ohmic pattern OL1 may include an Au/Be alloy, and the second ohmic pattern OL2 may include an Au/Ge alloy.

The light emitting device may further include an adhesion part AD which bonds the first light emitting part LEI, the second light emitting part LE2 and the third light emitting part LE3 with one another among the first light emitting part LEI, the second light emitting part LE2 and the third light emitting part LE3. For instance, the adhesion part AD may be disposed to fill between the first semiconductor structure SC1 and the second semiconductor structure SC2 disposed on the common n-type semiconductor layer COM_N and fill between the first and second semiconductor structures SC1 and SC2 and the third light emitting part LE3.

According to an embodiment, the adhesion part AD may include a transparent insulating material. The adhesion part AD may include glass, a polymer, a resist or a polyimide. For example, the adhesion part AD may include SOG (spin-on-glass), BCB (benzo cyclo butadiene), HSQ (hydrogen silsesquioxanes) or an SU-8 photoresist.

According to an embodiment, in the case where the common n-type semiconductor layer COM N is smaller than the third light emitting part LE3, the adhesion part AD may be disposed while surrounding the outer sidewall of the common n-type semiconductor layer COM_N.

While not shown, a color filter may be additionally provided between the first and second light emitting parts LE1 and LE2 and the third light emitting part LE3. The color filter may pass selectively the light emitted from the third light emitting part LE3 and may block the light emitted from the first light emitting part LE1 and the second light emitting part LE2.

The light emitting device may further include a first pad P1 which is electrically coupled with the first transparent electrode layer 114 of the first light emitting part LEI, a second pad P2 which is electrically coupled with the second transparent electrode layer 214 of the second light emitting part LE2, a third pad P3 which is electrically coupled with the second ohmic pattern OL2 of the third light emitting part LE3, and a common pad CPD which is electrically coupled with the first ohmic pattern OL1 and the common n-type semiconductor layer COM_N.

A passivation layer PVT may be additionally provided on the third n-type semiconductor layer 305 of the third light emitting part LE3. The passivation layer PVT may include SiNx, TiNx, TiOx, TaOx, ZrOx, AlOx, HfOx, or other. Each of the first pad PD1, the second pad PD2, the third pad PD3 and the common pad CPD may be disposed on the passivation layer PVT.

The light emitting device may further include a first through electrode VE1 which passes through the passivation layer PVT, the third light emitting part LE3 and the adhesion part AD to electrically couple the first pad PD1 and the first transparent electrode layer 114, a second through electrode VE2 which passes through the passivation layer PVT, the third light emitting part LE3 and the adhesion part AD to electrically couple the second pad PD2 and the second transparent electrode layer 214, and a third through electrode VE3 which passes through the passivation layer PVT and the third light emitting part LE3 to electrically couple the third pad PD3 and the second ohmic pattern OL2.

The light emitting device may further include a fourth through electrode VE4 which passes through the passivation layer PVT and the third n-type semiconductor layer 305 to electrically couple the common pad CPD and the third n-type semiconductor layer 305, and a fifth through electrode VE5 which passes through the passivation layer PVT, the third light emitting part LE3 and the adhesion part AD to electrically couple the common pad CPD and the common n-type semiconductor layer COM_N. According to an embodiment, the fifth through electrode VE5 may be electrically coupled with the common n-type semiconductor layer COM_N which is exposed between the first semiconductor structure SC1 and the second semiconductor structure SC2. For instance, the fifth through electrode VE5 may be disposed at the center of the light emitting device.

Each of the first through electrode VE1, the second through electrode VE2, the third through electrode VE3, the fourth through electrode VE4 and the fifth through electrode VE5 may include an electrode layer EL, a seed layer SL which surrounds the outer sidewall of the electrode layer EL and a barrier layer BL which surrounds the seed layer SL. The electrode layer EL and the seed layer SD may include a metal such as Cu, and the barrier layer BL may include at least one selected from the group consisting of Ti, W, Ni, and Ta. For example, the barrier layer BL may include Ti/W, Ti/Ni, Ta, TaN, or others.

According to embodiments shown in FIGS. 1B and ID, the first through electrode VE1 is integrated with the first pad PD1, and a portion which extends onto the passivation layer PVT serves as the first pad PD1. The second through electrode VE2 is integrated with the second pad PD2, and a portion which extends onto the passivation layer PVT serves as the second pad PD2. The third through electrode VE3 is integrated with the third pad PD3, and a portion which extends onto the passivation layer PVT serves as the third pad PD3. The fourth through electrode VE4 and the fifth through electrode VE5 are integrated with the common pad CPD, and portions which extend onto the passivation layer PVT serve as the common pad CPD.

According to another embodiment shown in FIG. 1C, the first pad PD1 may be disposed on the first through electrode VE1, the second pad PD2 may be disposed on the second through electrode VE2, the third pad PD3 may be disposed on the third through electrode VE3, and the common pad CPD may be disposed on the fourth through electrode VE4 and the fifth through electrode VE5. Each of the first pad PD1, the second pad PD2, the third pad PD3 and the common pad CPD may include at least one selected from the group consisting of Au, Ag, Ni, Al, Rh, Pd, Ir, Ru, Mg, Zn, Pt, Hf, Cr, Ti and Cu. Further, each of the first pad PD1, the second pad PD2, the third pad PD3 and the common pad CPD may include an alloy of the materials listed above.

When viewed from the top, in the case where the substrate 100 has a quadrangular structure as shown in FIG. 1A, the first pad PD1, the second pad PD2, the third pad PD3 and the common pad CPD may be disposed at corner portions of the substrate 100. According to an embodiment, when the fifth through electrode VE5 is disposed at the center of the light emitting device, the common pad CPD may have a structure which extends from the periphery to the center of the substrate 100. As the common pad CPD extends from the periphery to the center of the substrate 100, the concentration of current on the periphery in the case where the common pad CPD is disposed at only the periphery may be mitigated and current may be distributed over a wide area.

Referring again to FIGS. 1A and 1B, the light emitting device may further include a first metal pattern M1 which is disposed between the first transparent electrode layer 114 and the first through electrode VE1, a second metal pattern M2 which is disposed between the second transparent electrode layer 214 and the second through electrode VE2, a third metal pattern M3 which is disposed between the second ohmic pattern OL2 and the third through electrode VE3, a fourth metal pattern M4 which is disposed between the first ohmic pattern OL1 and the fourth through electrode VE4, and a fifth metal pattern M5 which is disposed between the common n-type semiconductor layer COM_N and the fifth through electrode VE5. Each of the first metal pattern M1, the second metal pattern M2, the third metal pattern M3, the fourth metal pattern M4 and the fifth metal pattern M5 may include at least one selected from the group consisting of Ti, Cr, Au and Al. For example, each of the first metal pattern M1, the second metal pattern M2, the third metal pattern M3, the fourth metal pattern M4 and the fifth metal pattern M5 may include Cr/Au, Ti/Al or Cr/Al.

The first metal pattern M1 may improve the ohmic property between the first transparent electrode layer 114 and the first through electrode VE1, between the first transparent electrode layer 114 and the first through electrode VE1. The second metal pattern M2 may improve the ohmic property between the second transparent electrode layer 214 and the second through electrode VE2, between the second transparent electrode layer 214 and the second through electrode VE2. The third metal pattern M3 may improve the ohmic property between the second ohmic pattern OL2 and the third through electrode VE3, between the second ohmic pattern OL2 and the third through electrode VE3. The fourth metal pattern M4 may improve the ohmic property between the first ohmic pattern OL1 and the fourth through electrode VE4, between the first ohmic pattern OL1 and the fourth through electrode VE4. The fifth metal pattern M5 may improve the ohmic property between the common n-type semiconductor layer COM_N and the fifth through electrode VE5, between the common n-type semiconductor layer COM_N and the fifth through electrode VE5.

The light emitting device may further include a dielectric layer DL which surrounds the outer sidewall of each of the first through electrode VE1, the second through electrode VE2, the third through electrode VE3, the fourth through electrode VE4 and the fifth through electrode VE5. The dielectric layer DL may include at least one selected from the group consisting of SiNx, TiNx, TiOx, TaOx, ZrOx, HfOx and SiOx.

Referring to FIG. ID, the light emitting device may further include a first solder structure SS1 which is disposed on the first pad PD1, a second solder structure SS2 which is disposed on the second pad PD2, a third solder structure SS3 which is disposed on the third pad PD3, and a fourth solder structure SS4 which is disposed on the common pad CPD. For instance, each of the first solder structure SS1, the second solder structure SS2, the third solder structure SS3 and the fourth solder structure SS4 may have a structure in which a solder ball SD including In or Sn and a barrier layer BRL including one of Ni, Co, Ti and Fe are stacked.

While it is described as an example in the present embodiment that the common pad CPD electrically couples the common n-type semiconductor layer COM_N and the third n-type semiconductor layer 305, it is to be noted that the common pad CPD may electrically couple the first transparent electrode layer 114, the second transparent electrode layer 214 and the second ohmic pattern OL2.

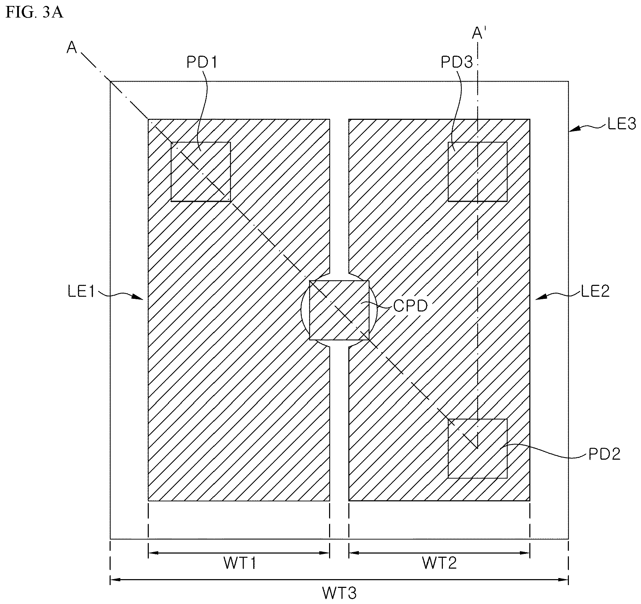

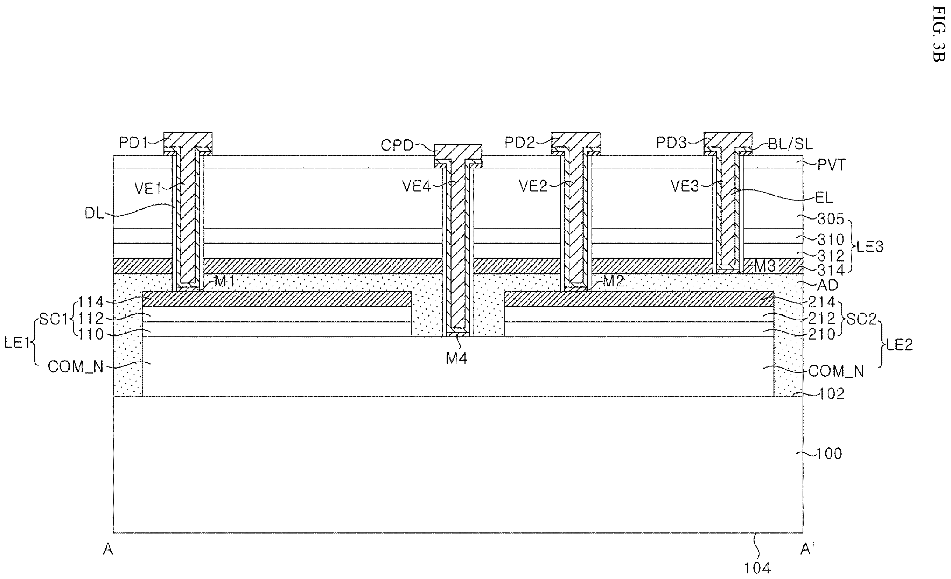

FIG. 3A is a representation of an example of a top view to assist in the explanation of a light emitting device in accordance with another embodiment of the disclosure, and FIG. 3B is a cross-sectional view taken along the line A-A' of FIG. 3A.

Referring to FIGS. 3A and 3B, a light emitting device may include a substrate 100, a first light emitting part LE1 and a second light emitting part LE2 which are disposed on the same plane on a first surface 102 of the substrate 100, and a third light emitting part LE3 which is disposed over the first light emitting part LE1 and the second light emitting part LE2.

According to an embodiment, in the case where a second surface 104 of the substrate 100 which faces away from the first surface 102 is a light extraction surface, the third light emitting part LE3 may emit red light, the first light emitting part LE1 may emit blue light or green light, and the second light emitting part LE2 may emit green light or blue light.

The first light emitting part LE1 may include a common n-type semiconductor layer COM_N, and a first semiconductor structure SC1 which includes a first active layer 110, a first p-type semiconductor layer 112 and a first transparent electrode layer 114 vertically stacked. The second light emitting part LE2 may include the common n-type semiconductor layer COM_N, and a second semiconductor structure SC2 which includes a second active layer 210, a second p-type semiconductor layer 212 and a second transparent electrode layer 214 vertically stacked. The first semiconductor structure SC1 and the second semiconductor structure SC2 may be disposed on the common n-type semiconductor layer COM_N in such a way as to be separated from each other. That is to say, the common n-type semiconductor layer COM N may be exposed between the first semiconductor structure SC1 and the second semiconductor structure SC2. The third light emitting part LE3 may include a third transparent electrode layer 314, a third p-type semiconductor layer 312, a third active layer 310 and a third n-type semiconductor layer 305 which are vertically stacked.

According to an embodiment, each of the first transparent electrode layer 114, the second transparent electrode layer 214 and the third transparent electrode layer 314 may include a transparent conductive oxide (TCO) such as ZnO, ITO, ZITO, ZIO, GIO, ZTO, FTO, GZO, AZO, or others.

The light emitting device may further include an adhesion part AD which bonds the first light emitting part LEI, the second light emitting part LE2 and the third light emitting part LE3 with one another among the first light emitting part LEI, the second light emitting part LE2 and the third light emitting part LE3. For instance, the adhesion part AD may be disposed to fill between the first semiconductor structure SC1 and the second semiconductor structure SC2 disposed on the common n-type semiconductor layer COM_N and fill between the first and second semiconductor structures SC1 and SC2 and the third light emitting part LE3. For example, the adhesion part AD may include a material such as SOG, BCB, HSQ or an SU-8 photoresist, which is transparent and has a bonding property.

The light emitting device may further include a first pad P1 which is electrically coupled with the first transparent electrode layer 114 of the first light emitting part LEI, a second pad P2 which is electrically coupled with the second transparent electrode layer 214 of the second light emitting part LE2, a third pad P3 which is electrically coupled with the third transparent electrode layer 314 of the third light emitting part LE3, and a common pad CPD which is electrically coupled with the third n-type semiconductor layer 305 and the common n-type semiconductor layer COM_N.

A passivation layer PVT may be additionally provided on the third n-type semiconductor layer 305 of the third light emitting part LE3. Each of the first pad PD1, the second pad PD2 and the third pad PD3 may be disposed on the passivation layer PVT, and the common pad CPD may pass through the passivation layer PVT and be brought into electrical contact with the third n-type semiconductor layer 305 and the common n-type semiconductor layer COM_N.

The light emitting device may further include a first through electrode VE1 which passes through the passivation layer PVT, the third light emitting part LE3 and the adhesion part AD to electrically couple the first pad PD1 and the first transparent electrode layer 114, a second through electrode VE2 which passes through the passivation layer PVT, the third light emitting part LE3 and the adhesion part AD to electrically couple the second pad PD2 and the second transparent electrode layer 214, and a third through electrode VE3 which passes through the passivation layer PVT and the third light emitting unit LE3 to electrically couple the third pad PD3 and the third transparent electrode layer 314. According to an embodiment, the first through electrode VE1 and the second through electrode VE2 may have the same height.

The light emitting device may further include a fourth through electrode VE4 which passes through the third light emitting part LE3 and the adhesion part AD to electrically couple the common pad CPD brought into electrical contact with the third n-type semiconductor layer 305, with the common n-type semiconductor layer COM_N. According to an embodiment, the fourth through electrode VE4 may be disposed between the first semiconductor structure SC1 and the second semiconductor structure SC2. For instance, the fourth through electrode VE4 may be disposed at the center of the substrate 100.

Each of the first through electrode VE1, the second through electrode VE2, the third through electrode VE3, and the fourth through electrode VE4 may include an electrode layer EL, a seed layer SL which surrounds the outer sidewall of the electrode layer EL and a barrier layer BL which surrounds the seed layer SL. The electrode layer EL and the seed layer SL may include a metal such as Cu, and the barrier layer BL may include at least one selected from the group consisting of Ti, W, Ni, and Ta. For example, the barrier layer BL may include Ti/W, Ti/Ni, Ta/TaN or others.

When viewed from the top, in the case where the substrate 100 has a quadrangular structure, the first pad PD1, the second pad PD2 and the third pad PD3 may be disposed at corner portions of the substrate 100, and the common pad CPD may be disposed at the center of the substrate 100.

The light emitting device may further include a first metal pattern M1 which is disposed between the first transparent electrode layer 114 and the first through electrode VE1, a second metal pattern M2 which is disposed between the second transparent electrode layer 214 and the second through electrode VE2, a third metal pattern M3 which is disposed between the third transparent electrode layer 314 and the third through electrode VE3, and a fourth metal pattern M4 which is disposed between the common n-type semiconductor layer COM_N and the fourth through electrode VE4. Each of the first metal pattern M1, the second metal pattern M2, the third metal pattern M3 and the fourth metal pattern M4 may include at least one selected from the group consisting of Ti, Cr, Au and Al. For example, each of the first metal pattern M1, the second metal pattern M2, the third metal pattern M3, and the fourth metal pattern M4 may include Cr/Au, Ti/Al or Cr/Al.

The light emitting device may further include a dielectric layer DL which surrounds the outer sidewall of each of the first through electrode VE1, the second through electrode VE2, the third through electrode VE3 and the fourth through electrode VE4.

Since the components and the characteristics of the light emitting device which are not described in detail with reference to FIGS. 3A and 3B are the same as the components and the characteristics of the light emitting device which are described above with reference to FIGS. 1A and 1B, detailed descriptions thereof will be omitted herein.

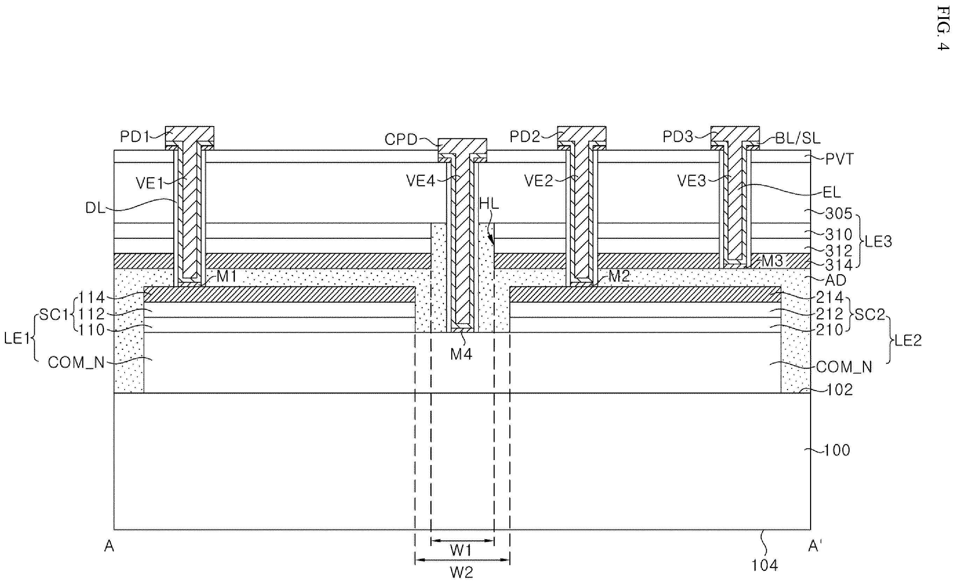

FIG. 4 is a representation of an example of a cross-sectional view to assist in the explanation of a light emitting device in accordance with another embodiment of the disclosure. For the top view of the light emitting device of FIG. 4, reference may be made to FIG. 3A.

Referring to FIGS. 3A and 4, a light emitting device may include a substrate 100, a first light emitting part LE1 and a second light emitting part LE2 which are disposed on the same plane on a first surface 102 of the substrate 100, and a third light emitting part LE3 which is disposed over the first light emitting part LE1 and the second light emitting part LE2. A second surface 104 of the substrate 100 which faces away from the first surface 102 may be a light extraction surface.

The first light emitting part LE1 may include a common n-type semiconductor layer COM_N, and a first semiconductor structure SC1 which includes a first active layer 110, a first p-type semiconductor layer 112 and a first transparent electrode layer 114 vertically stacked. The second light emitting part LE2 may include the common n-type semiconductor layer COM_N, and a second semiconductor structure SC2 which includes a second active layer 210, a second p-type semiconductor layer 212 and a second transparent electrode layer 214 vertically stacked. The first semiconductor structure SC1 and the second semiconductor structure SC2 may be disposed on the common n-type semiconductor layer COM_N in such a way as to be separated from each other. That is to say, the common n-type semiconductor layer COM N may be exposed between the first semiconductor structure SC1 and the second semiconductor structure SC2.

The third light emitting part LE3 may include a third transparent electrode layer 314, a third p-type semiconductor layer 312, a third active layer 310 and a third n-type semiconductor layer 305 which are vertically stacked. According to an embodiment, the third light emitting part LE3 may include a hole HL which exposes a portion of the third n-type semiconductor layer 305, by etching portions of the third transparent electrode layer 314, the third p-type semiconductor layer 312 and the third active layer 310. The hole HL of the third light emitting part LE3 may be a position corresponding to at least a portion of the common n-type semiconductor layer COM_N which is exposed between the first semiconductor structure SC1 and the second semiconductor structure SC2. A width W1 of the hole HL may be smaller than a width W2 of the common n-type semiconductor layer COM_N which is exposed between the first semiconductor structure SC1 and the second semiconductor structure SC2.

The light emitting device may further include an adhesion part AD which bonds the first light emitting part LEI, the second light emitting part LE2 and the third light emitting part LE3 with one another among the first light emitting part LEI, the second light emitting part LE2 and the third light emitting part LE3. For instance, the adhesion part AD may be disposed to fill between the first semiconductor structure SC1 and the second semiconductor structure SC2 disposed on the common n-type semiconductor layer COM_N and fill between the first and second semiconductor structures SC1 and SC2 and the third light emitting part LE3. According to an embodiment, the adhesion part AD may be disposed while filling the inside of the hole HL of the third light emitting part LE3.

The light emitting device may further include a first through electrode VE1 and a first pad P1 which are electrically coupled with the first transparent electrode layer 114, a second through electrode VE2 and a second pad P2 which are electrically coupled with the second transparent electrode layer 214, a third through electrode VE3 and a third pad P3 which are electrically coupled with the third transparent electrode layer 314, and a fourth through electrode VE4 and a common pad CPD which are electrically coupled with the third n-type semiconductor layer 305 and the common n-type semiconductor layer COM_N. The light emitting device may further include a passivation layer PVT on the third n-type semiconductor layer 305, and a dielectric layer DL which surrounds the outer sidewall of each of the first through electrode VE1, the second through electrode VE2 and the third through electrode VE3. According to an embodiment, the dielectric layer DL may not be disposed on the outer sidewall of the fourth through electrode VE4.

According to an embodiment, the common pad CPD may pass through the passivation layer PVT and be brought into electrical contact with the third n-type semiconductor layer 305. The fourth through electrode VE4 which is electrically coupled with the common pad CPD may pass through the third n-type semiconductor layer 305 and be disposed in the hole HL of the third light emitting part LE3. Although the dielectric layer DL is not disposed on the outer sidewall of the fourth through electrode VE4, since the adhesion part AD which includes a transparent insulating material is disposed in the hole HL of the third light emitting part LE3, the fourth through electrode VE4 may be insulated from the third active layer 310, the third p-type semiconductor layer 312 and the third transparent electrode layer 314 of the third light emitting part LE3. Also, as the adhesion part AD fills between the first semiconductor structure SC1 and the second semiconductor structure SC2, the fourth through electrode VE4 which is brought into electrical contact with the common n-type semiconductor layer COM N may be insulated from the first semiconductor structure SC1 and the second semiconductor structure SC2.

Since the components and the characteristics of the light emitting device which are not described in detail with reference to FIG. 4 are the same as the components and the characteristics of the light emitting devices which are described above with reference to FIGS. 1A, 1B, 3A and 3B, detailed descriptions thereof will be omitted herein.

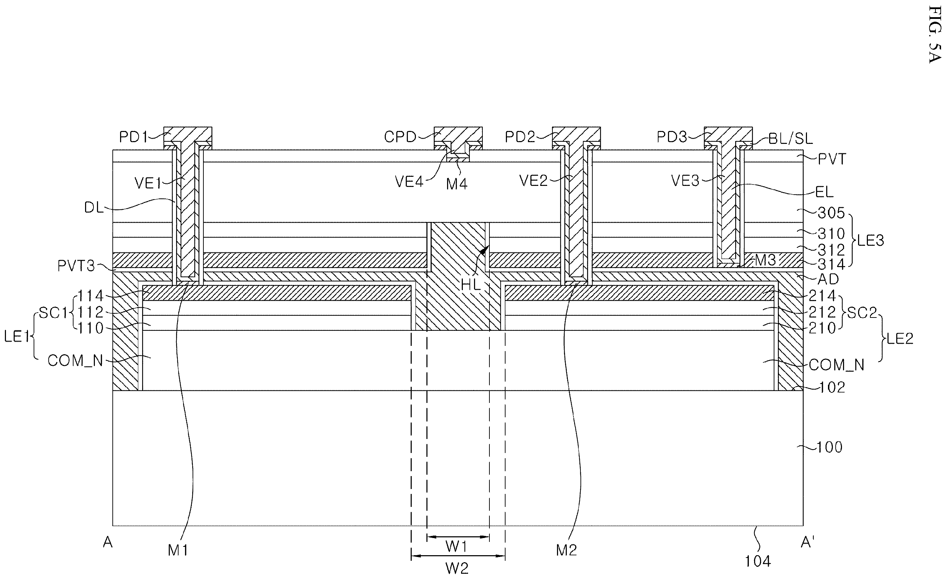

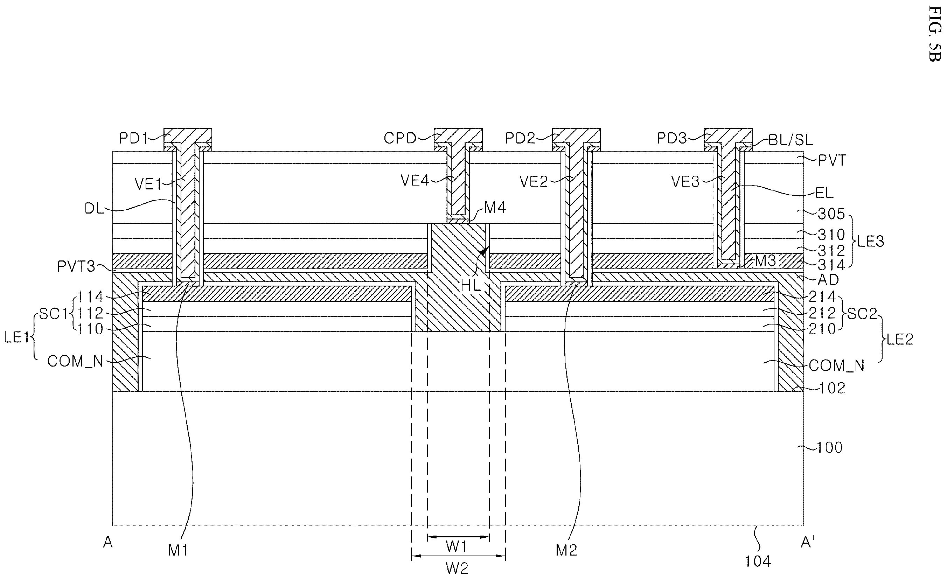

FIGS. 5A and 5B are representations of examples of cross-sectional views to assist in the explanation of light emitting devices in accordance with other embodiments of the disclosure. For the top views of the light emitting devices of FIGS. 5A and 5B, reference may be made to FIG. 3A.

Referring to FIGS. 3A, 5A and 5B, a light emitting device may include a substrate 100, a first light emitting part LE1 and a second light emitting part LE2 which are disposed on the same plane on a first surface 102 of the substrate 100, and a third light emitting part LE3 which is disposed over the first light emitting part LE1 and the second light emitting part LE2. A second surface 104 of the substrate 100 which faces away from the first surface 102 may be a light extraction surface.

The first light emitting part LE1 may include a common n-type semiconductor layer COM_N, and a first semiconductor structure SC1 which includes a first active layer 110, a first p-type semiconductor layer 112 and a first transparent electrode layer 114 vertically stacked. The second light emitting part LE2 may include the common n-type semiconductor layer COM_N, and a second semiconductor structure SC2 which includes a second active layer 210, a second p-type semiconductor layer 212 and a second transparent electrode layer 214 vertically stacked. The first semiconductor structure SC1 and the second semiconductor structure SC2 may be disposed on the common n-type semiconductor layer COM_N in such a way as to be separated from each other. That is to say, the common n-type semiconductor layer COM_N may be exposed between the first semiconductor structure SC1 and the second semiconductor structure SC2.

The third light emitting part LE3 may include a third transparent electrode layer 314, a third p-type semiconductor layer 312, a third active layer 310 and a third n-type semiconductor layer 305 which are vertically stacked. According to an embodiment, the third light emitting part LE3 may include a hole HL which exposes a portion of the third n-type semiconductor layer 305, by etching portions of the third transparent electrode layer 314, the third p-type semiconductor layer 312 and the third active layer 310. The hole HL of the third light emitting part LE3 may be a position corresponding to at least a portion of the common n-type semiconductor layer COM_N which is exposed between the first semiconductor structure SC1 and the second semiconductor structure SC2. A width W1 of the hole HL may be smaller than a width W2 of the common n-type semiconductor layer COM_N which is exposed between the first semiconductor structure SC1 and the second semiconductor structure SC2.

The light emitting device may further include a first passivation layer PVT1 which covers the first semiconductor structure SC1 on the first transparent electrode layer 114, a second passivation layer PVT2 which covers the second semiconductor structure SC2 on the second transparent electrode layer 214, a third passivation layer PVT3 which covers one surface of the third light emitting part LE3 on the third transparent electrode layer 314, and a fourth passivation layer PVT4 which covers the other surface of the third light emitting part LE3 facing away from the one surface on the third n-type semiconductor layer 305. For example, each of the first passivation layer PVT1, the second passivation layer PVT2, the third passivation layer PVT3 and the fourth passivation layer PVT4 may include an insulating material including at least one selected from the group consisting of SiNx, TiNx, TiOx, TaOx, ZrOx, AlOx, or HfOx.

According to an embodiment, since the first passivation layer PVT1 and the second passivation layer PVT2 are not disposed on the common n-type semiconductor layer COM_N which is disposed between the first semiconductor structure SC1 and the second semiconductor structure SC2, the common n-type semiconductor layer COM_N which is disposed between the first semiconductor structure SC1 and the second semiconductor structure SC2 may be exposed. Also, since the third passivation layer PVT3 is not disposed at the bottom of the hole HL, the third n-type semiconductor layer 305 may be exposed at the bottom of the hole HL.

The light emitting device may further include an adhesion part AD which bonds the first light emitting part LEI, the second light emitting part LE2 and the third light emitting part LE3 with one another among the first light emitting part LEI, the second light emitting part LE2 and the third light emitting part LE3. For instance, the adhesion part AD may be disposed to fill between the first semiconductor structure SC1 and the second semiconductor structure SC2 disposed on the common n-type semiconductor layer COM_N and fill between the first and second semiconductor structures SC1 and SC2 and the third light emitting part LE3. According to an embodiment, the adhesion part AD may be disposed while filling the inside of the hole HL of the third light emitting part LE3.

According to an embodiment, the adhesion part AD may include a material which is transparent and has an electrical conductivity and a bonding property. For example, the adhesion part AD may include a material such as transparent conductive oxide (TCO), isotropic conductive adhesives (ICA), anisotropic conductive adhesives (ACA), or others .

The light emitting device may further include a first through electrode VE1 and a first pad P1 which are electrically coupled with the first transparent electrode layer 114, a second through electrode VE2 and a second pad P2 which are electrically coupled with the second transparent electrode layer 214, a third through electrode VE3 and a third pad P3 which are electrically coupled with the third transparent electrode layer 314, and a fourth through electrode VE4 and a common pad CPD which are electrically coupled with the third n-type semiconductor layer 305. The light emitting device may further include a passivation layer PVT on the third n-type semiconductor layer 305, and a dielectric layer DL which surrounds the outer sidewall of each of the first through electrode VE1, the second through electrode VE2 and the third through electrode VE3. According to an embodiment, the dielectric layer DL may not be disposed on the outer sidewall of the fourth through electrode VE4.

According to an embodiment shown in FIG. 5A, the fourth through electrode VE4 may pass through the passivation layer PVT, and may be brought into electrical contact with one surface of the third n-type semiconductor layer 305. Since, as described above, the adhesion part AD includes a material which has an electrical conductivity, the fourth through electrode VE4 may be electrically coupled with the one surface of the third n-type semiconductor layer 305, and the third n-type semiconductor layer 305 which is exposed by the hole HL of the third light emitting part LE3 may be brought into electrical contact with the adhesion part AD The adhesion part AD may be brought into electrical contact with the common n-type semiconductor layer COM_N which is exposed between the first semiconductor structure SC1 and the second semiconductor structure SC2. Therefore, the common pad CPD may be electrically coupled with the third n-type semiconductor layer 305, the adhesion part AD and the common n-type semiconductor layer COM_N through the fourth through electrode VE4.

According to another embodiment shown in FIG. 5B, the fourth through electrode VE4 may pass through the passivation layer PVT and the third n-type semiconductor layer 305 of the third light emitting part LE3, and may be brought into electrical contact with the third n-type semiconductor layer 305. In this case, as the outer sidewall of the fourth through electrode VE4 is brought into electrical contact with the third n-type semiconductor layer 305, an area through which the fourth through electrode VE4 and the third n-type semiconductor layer 305 are brought into contact with each other may be increased. The fourth through electrode VE4 may be brought into electrical contact with the adhesion part AD which is filled in the hole HL of the third light emitting part LE3. The adhesion part AD may be brought into electrical contact with the common n-type semiconductor layer COM_N which is exposed between the first semiconductor structure SC1 and the second semiconductor structure SC2. Therefore, the common pad CPD may be electrically coupled with the third n-type semiconductor layer 305, the adhesion part AD and the common n-type semiconductor layer COM_N through the fourth through electrode VE4.

While it is illustrated in FIG. 5B that the fourth through electrode VE4 passes through the passivation layer PVT and the third n-type semiconductor layer 305 of the third light emitting part LE3, it is to be noted that the fourth through electrode VE4 may pass through the passivation layer PVT and the third n-type semiconductor layer 305 of the third light emitting part LE3 and pass through at least a portion of the adhesion part AD. Alternatively, the fourth through electrode VE4 may pass through the passivation layer PVT and the third n-type semiconductor layer 305 of the third light emitting part LE3, and may pass through the adhesion part AD and be brought into contact with the common n-type semiconductor layer COM_N which is exposed between the first semiconductor structure SC1 and the second semiconductor structure SC2.

Since the components and the characteristics of the light emitting devices which are not described in detail with reference to FIGS. 5A and 5B are the same as the components and the characteristics of the light emitting devices which are described above with reference to FIGS. 1A, 1B, 3A, 3B, 4A and 4B, detailed descriptions thereof will be omitted herein.

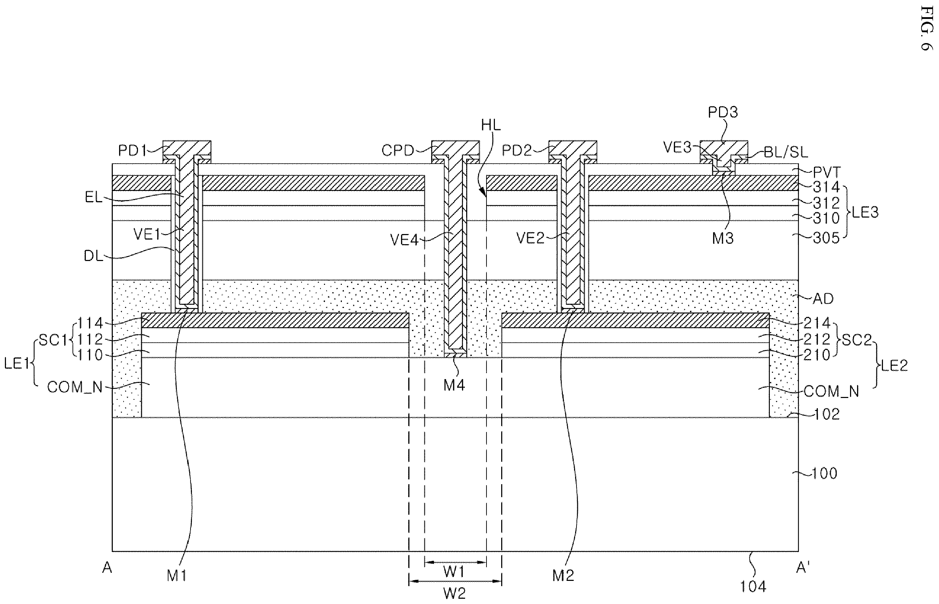

FIG. 6 is a representation of an example of a cross-sectional view to assist in the explanation of a light emitting device in accordance with another embodiment of the disclosure. For the top view of the light emitting device of FIG. 6, reference may be made to FIG. 3A.

Referring to FIGS. 3A and 6, a light emitting device may include a substrate 100, a first light emitting part LE1 and a second light emitting part LE2 which are disposed on the same plane on a first surface 102 of the substrate 100, and a third light emitting part LE3 which is disposed over the first light emitting part LE1 and the second light emitting part LE2. A second surface 104 of the substrate 100 which faces away from the first surface 102 may be a light extraction surface.

The first light emitting part LE1 may include a common n-type semiconductor layer COM_N, and a first semiconductor structure SC1 which includes a first active layer 110, a first p-type semiconductor layer 112 and a first transparent electrode layer 114 vertically stacked. The second light emitting part LE2 may include the common n-type semiconductor layer COM_N, and a second semiconductor structure SC2 which includes a second active layer 210, a second p-type semiconductor layer 212 and a second transparent electrode layer 214 vertically stacked. The first semiconductor structure SC1 and the second semiconductor structure SC2 may be disposed on the common n-type semiconductor layer COM_N in such a way as to be separated from each other. That is to say, the common n-type semiconductor layer COM_N may be exposed between the first semiconductor structure SC1 and the second semiconductor structure SC2.

The third light emitting part LE3 may include a third n-type semiconductor layer 305, a third active layer 310, a third p-type semiconductor layer 312 and a third transparent electrode layer 314 which are vertically stacked. According to an embodiment, the third light emitting part LE3 may include a hole HL which exposes a portion of the third n-type semiconductor layer 305, by etching portions of the third transparent electrode layer 314, the third p-type semiconductor layer 312 and the third active layer 310. The hole HL of the third light emitting part LE3 may be a position corresponding to at least a portion of the common n-type semiconductor layer COM_N which is exposed between the first semiconductor structure SC1 and the second semiconductor structure SC2. A width W1 of the hole HL may be smaller than a width W2 of the common n-type semiconductor layer COM_N which is exposed between the first semiconductor structure SC1 and the second semiconductor structure SC2.

The light emitting device may further include an adhesion part AD which bonds the first light emitting part LEI, the second light emitting part LE2 and the third light emitting part LE3 with one another among the first light emitting part LEI, the second light emitting part LE2 and the third light emitting part LE3. For instance, the adhesion part AD may be disposed to fill between the first semiconductor structure SC1 and the second semiconductor structure SC2 disposed on the common n-type semiconductor layer COM_N and fill between the first and second semiconductor structures SC1 and SC2 and the third light emitting part LE3. For example, the adhesion part AD may include a material such as SOG, BCB, HSQ or an SU-8 photoresist, which is transparent and has a bonding property .

The light emitting device may further include a first through electrode VE1 and a first pad P1 which are electrically coupled with the first transparent electrode layer 114, a second through electrode VE2 and a second pad P2 which are electrically coupled with the second transparent electrode layer 214, a third through electrode VE3 and a third pad P3 which are electrically coupled with the third transparent electrode layer 314, and a fourth through electrode VE4 and a common pad CPD which are electrically coupled with the third n-type semiconductor layer 305 and the common n-type semiconductor layer COM_N.

The light emitting device may further include a passivation layer PVT which is disposed on the third transparent electrode layer 314, and a dielectric layer DL which surrounds the outer sidewall of each of the first through electrode VE1 and the second through electrode VE2. According to an embodiment, the passivation layer PVT may fill the hole HL of the third light emitting part LE3, and may extend to the top surface of the third transparent electrode layer 314. The dielectric layer DL may not be disposed on the outer sidewall of each of the third through electrode VE3 and the fourth through electrode VE4.

According to an embodiment, the third through electrode VE3 may pass through the passivation layer PVT and be brought into electrical contact with the third transparent electrode layer 314. Because the third through electrode VE3 is insulated from an outside by the passivation layer PVT, the dielectric layer DL which additionally surrounds the outer sidewall of the third through electrode VE3 may not be needed.

According to an embodiment, the fourth through electrode VE4 may pass through the passivation layer PVT filling the hole HL of the third light emitting part LE3, the third n-type semiconductor layer 305 and the adhesion part AD. Because the fourth through electrode VE4 passes through the hole HL which is filled with the passivation layer PVT, the dielectric layer DL which surrounds the outer sidewall of the fourth through electrode VE4 may not be needed. Further, since the dielectric layer DL does not surround the outer sidewall of the fourth through electrode VE4, while the fourth through electrode VE4 passes through the third n-type semiconductor layer 305, the outer sidewall of the fourth through electrode VE4 may be brought into electrical contact with the third n-type semiconductor layer 305, and thus, an area through which the fourth through electrode VE4 and the third n-type semiconductor layer 305 are brought into contact with each other may be increased. The fourth through electrode VE4 may pass through the adhesion part AD including an insulating material, and may be brought into electrical contact with the common n-type semiconductor layer COM_N. By this fact, the fourth through electrode VE4 may be brought into electrical contact with the third n-type semiconductor layer 305 and the common n-type semiconductor layer COM_N.

Since the components and the characteristics of the light emitting device which are not described in detail with reference to FIG. 6 are the same as the components and the characteristics of the light emitting devices which are described above with reference to FIGS. 1A, 1B, 3A, 3B, 4A, 4B, 5A and 5B, detailed descriptions thereof will be omitted herein.

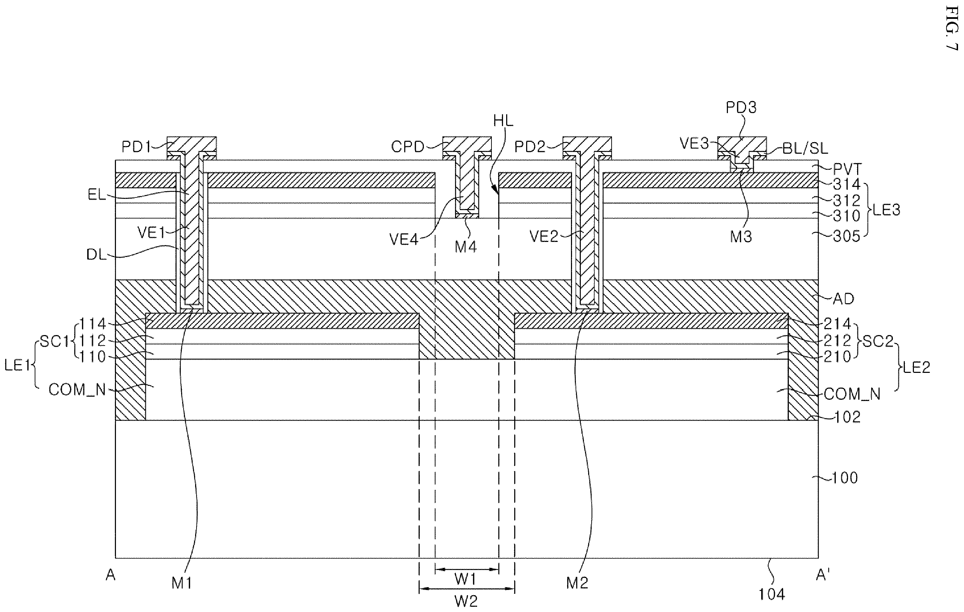

FIG. 7 is a representation of an example of a cross-sectional view to assist in the explanation of a light emitting device in accordance with another embodiment of the disclosure. For the top view of the light emitting device of FIG. 7, reference may be made to FIG. 3A.

Referring to FIGS. 3A and 7, a light emitting device may include a substrate 100, a first light emitting part LE1 and a second light emitting part LE2 which are disposed on the same plane on a first surface 102 of the substrate 100, and a third light emitting part LE3 which is disposed over the first light emitting part LE1 and the second light emitting part LE2. A second surface 104 of the substrate 100 which faces away from the first surface 102 may be a light extraction surface.

The first light emitting part LE1 may include a common n-type semiconductor layer COM_N, and a first semiconductor structure SC1 which includes a first active layer 110, a first p-type semiconductor layer 112 and a first transparent electrode layer 114 vertically stacked. The second light emitting part LE2 may include the common n-type semiconductor layer COM_N, and a second semiconductor structure SC2 which includes a second active layer 210, a second p-type semiconductor layer 212 and a second transparent electrode layer 214 vertically stacked. The first semiconductor structure SC1 and the second semiconductor structure SC2 may be disposed on the common n-type semiconductor layer COM_N in such a way as to be separated from each other. That is to say, the common n-type semiconductor layer COM_N may be exposed between the first semiconductor structure SC1 and the second semiconductor structure SC2.

The third light emitting part LE3 may include a third n-type semiconductor layer 305, a third active layer 310, a third p-type semiconductor layer 312 and a third transparent electrode layer 314 which are vertically stacked. According to an embodiment, the third light emitting part LE3 may include a hole HL which exposes a portion of the third n-type semiconductor layer 305, by etching portions of the third transparent electrode layer 314, the third p-type semiconductor layer 312 and the third active layer 310. The hole HL of the third light emitting part LE3 may be a position corresponding to at least a portion of the common n-type semiconductor layer COM_N which is exposed between the first semiconductor structure SC1 and the second semiconductor structure SC2. A width W1 of the hole HL may be smaller than a width W2 of the common n-type semiconductor layer COM_N which is exposed between the first semiconductor structure SC1 and the second semiconductor structure SC2.

The light emitting device may further include a first passivation layer PVT1 which covers the first semiconductor structure SC1 on the first transparent electrode layer 114, a second passivation layer PVT2 which covers the second semiconductor structure SC2 on the second transparent electrode layer 214, and a third passivation layer PVT3 which covers one surface of the third light emitting part LE3 on the third transparent electrode layer 314 and fills the hole HL of the third light emitting part LE3. For example, each of the first passivation layer PVT1, the second passivation layer PVT2 and the third passivation layer PVT3 may be an insulating material including at least one selected from the group consisting of SiNx, TiNx, TiOx, TaOx, ZrOx, HfOx, AlOx and SiOx. According to an embodiment, since the first passivation layer PVT1 and the second passivation layer PVT2 are not disposed on the common n-type semiconductor layer COM_N which is disposed between the first semiconductor structure SC1 and the second semiconductor structure SC2, the common n-type semiconductor layer COM_N which is disposed between the first semiconductor structure SC1 and the second semiconductor structure SC2 may be exposed.

The light emitting device may further include a first passivation layer PVT1 which covers the top surface and the side surface of the first semiconductor structure SC1, a second passivation layer PVT2 which covers the top surface and the side surface of the second semiconductor structure SC2, and a third passivation layer PVT3 which covers the inner sidewall of the hole HL of the third light emitting part LE3 and the top surface of the third transparent electrode layer 314. The first passivation layer PVT1, the second passivation layer PVT2 and the third passivation layer PVT3 may be an insulating material including at least one selected from the group consisting of SiNx, TiNx, TiOx, TaOx, ZrOx, HfOx, AlOx and SiOx. By the first passivation layer PVT1, the second passivation layer PVT2 and the third passivation layer PVT3, at least portions of the common n-type semiconductor layer COM_N and the third n-type semiconductor layer 305 may be exposed.

The light emitting device may further include an adhesion part AD which bonds the first light emitting part LEI, the second light emitting part LE2 and the third light emitting part LE3 with one another among the first light emitting part LEI, the second light emitting part LE2 and the third light emitting part LE3. For instance, the adhesion part AD may be disposed to fill between the first semiconductor structure SC1 and the second semiconductor structure SC2 disposed on the common n-type semiconductor layer COM_N and fill between the first and second semiconductor structures SC1 and SC2 and the third light emitting part LE3. According to an embodiment, the adhesion part AD may be disposed while filling the inside of the hole HL of the third light emitting part LE3.

According to an embodiment, the adhesion part AD may include a material which is transparent and has an electrical conductivity and a bonding property. For example, the adhesion part AD may include a material such as TCO, ICA, ACA, or others.

The light emitting device may further include a dielectric layer DL which surrounds the outer sidewall of each of the first through electrode VE1 and the second through electrode VE2. According to an embodiment, the dielectric layer DL may not be disposed on the outer sidewall of each of the third through electrode VE3 and the fourth through electrode VE4.

According to an embodiment, the third through electrode VE3 may pass through the third passivation layer PVT3 and be brought into electrical contact with the third transparent electrode layer 314. Because the third through electrode VE3 is insulated from an outside by the third passivation layer PVT3, the dielectric layer DL which additionally surrounds the outer sidewall of the third through electrode VE3 may not be needed.

According to an embodiment, the fourth through electrode VE4 may pass through the third passivation layer PVT3 filling the hole HL of the third light emitting part LE3, the third n-type semiconductor layer 305 and the adhesion part AD. Because the fourth through electrode VE4 passes through the hole HL which is filled with the third passivation layer PVT3, the dielectric layer DL which surrounds the outer sidewall of the fourth through electrode VE4 may not be needed. Further, since the dielectric layer DL does not surround the outer sidewall of the fourth through electrode VE4, while the fourth through electrode VE4 passes through the third n-type semiconductor layer 305, the outer sidewall of the fourth through electrode VE4 may be brought into electrical contact with the third n-type semiconductor layer 305, and thus, an area through which the fourth through electrode VE4 and the third n-type semiconductor layer 305 are brought into contact with each other may be increased. The fourth through electrode VE4 may be brought into electrical contact with the adhesion part AD which includes a material having an electrical conductivity. The adhesion part AD may be brought into electrical contact with the common n-type semiconductor layer COM_N which is exposed between the first semiconductor structure SC1 and the second semiconductor structure SC2. Therefore, the common pad CPD may be electrically coupled with the third n-type semiconductor layer 305, the adhesion part AD and the common n-type semiconductor layer COM_N through the fourth through electrode VE4.

Since the components and the characteristics of the light emitting device which are not described in detail with reference to FIG. 7 are the same as the components and the characteristics of the light emitting devices which are described above with reference to FIGS. 1A, 1B, 3A, 3B, 4A, 4B, 5A, 5B and 6, detailed descriptions thereof will be omitted herein.

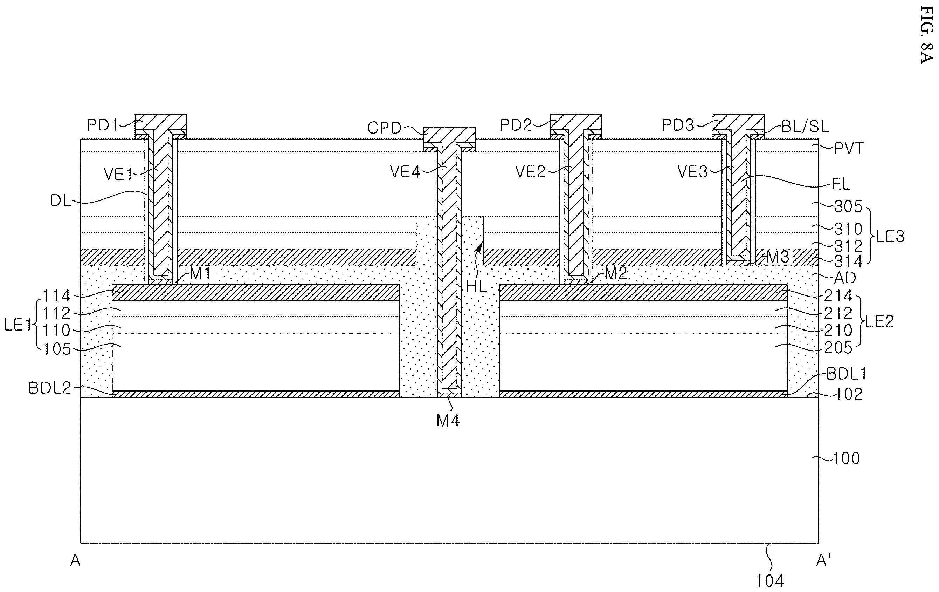

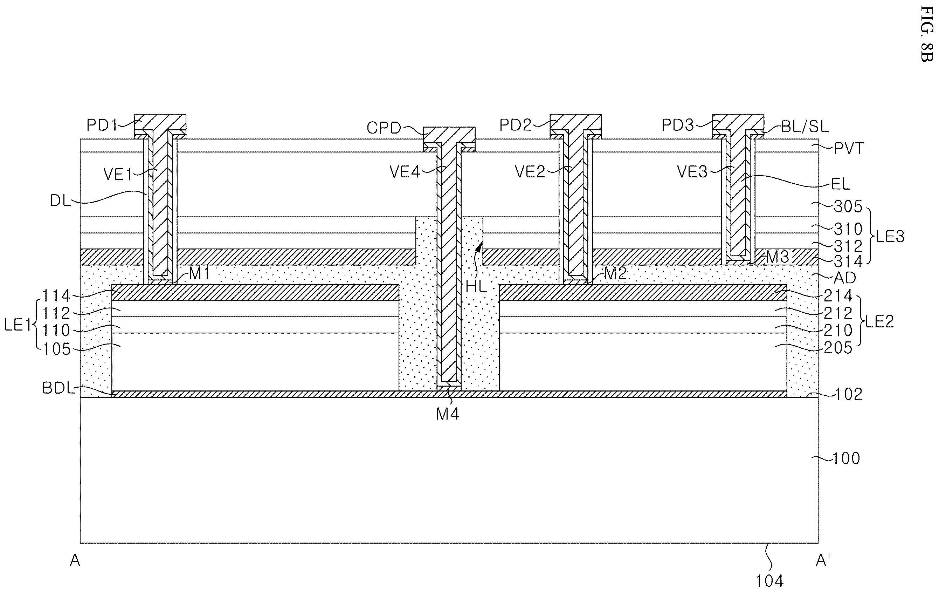

FIGS. 8A and 8B are representations of examples of cross-sectional views to assist in the explanation of light emitting devices in accordance with other embodiments of the disclosure. For the top views of the light emitting devices of FIGS. 8A and 8B, reference may be made to FIG. 3A.

Referring to FIGS. 3A, 8A and 8B, a light emitting device may include a substrate 100, a first light emitting part LE1 and a second light emitting part LE2 which are disposed on the same plane on a first surface 102 of the substrate 100, and a third light emitting part LE3 which is disposed over the first light emitting part LE1 and the second light emitting part LE2. A second surface 104 of the substrate 100 which faces away from the first surface 102 may be a light extraction surface.

The first light emitting part LE1 may include a first n-type semiconductor layer 105, a first active layer 110, a first p-type semiconductor layer 112 and a first transparent electrode layer 114 which are vertically stacked. The second light emitting part LE2 may include a second n-type semiconductor layer 205, a second active layer 210, a second p-type semiconductor layer 212 and a second transparent electrode layer 214 which are vertically stacked. The third light emitting part LE3 may include a third transparent electrode layer 314, a third p-type semiconductor layer 312, a third active layer 310 and a third n-type semiconductor layer 305 which are vertically stacked.

According to an embodiment shown in FIG. 8A, as the substrate 100, a conductive substrate such as Si, SiC, or others may be adopted. The first light emitting part LE1 and the second light emitting part may be separated from each other, and a portion of the substrate 100 may be exposed by the first light emitting part LE1 and the second light emitting part LE2. The first light emitting part LE1 may be bonded to the first surface 102 of the substrate 100 by a first bonding layer BDL1. The second light emitting part LE2 may be bonded to the first surface 102 of the substrate 100 by a second bonding layer BDL2, by being separated from the first light emitting part LE1. For example, each of the first bonding layer BDL1 and the second bonding layer BDL2 may include a conductive material such as a solder or metallic bonding material, for example, Au, AuSn, CuSn or others, TCO, ICA, or ACA. The first n-type semiconductor layer 105 of the first light emitting part LE1 may be electrically coupled with the substrate 100 by the first bonding layer BDL1, and the second n-type semiconductor layer 205 of the second light emitting part LE2 may be electrically coupled with the substrate 100 by the second bonding layer BDL2. Accordingly, the substrate 100, the first n-type semiconductor layer 105 and the second n-type semiconductor layer 205 may be electrically coupled with one another.

According to another embodiment shown in FIG. 8B, the substrate 100 may be a nonconductive substrate. The first light emitting part LE1 and the second light emitting part LE2 may be disposed by being separated from each other, and a bonding layer BDL may be disposed between the first and second light emitting parts LE1 and LE2 and the first surface 102 of the substrate 100. By the bonding layer BDL, the first light emitting part LE1 and the second light emitting part LE2 may be bonded to the first surface 102 of the substrate 100, by being separated from each other. For example, the bonding layer BDL may include a metal pattern and a conductive material such as a solder or metallic bonding material, for example, Au, AuSn, CuSn or others, TCO, ICA, or ACA. The bonding layer BDL may be electrically coupled with the first n-type semiconductor layer 105 of the first light emitting part LEI, and may be electrically coupled with the second n-type semiconductor layer 205 of the second light emitting part LE2. The bonding layer BDL may extend between the first light emitting part LE1 and the second light emitting part LE2. Accordingly, the bonding layer BDL, the first n-type semiconductor layer 105 and the second n-type semiconductor layer 205 may be electrically coupled with one another.

Referring to FIGS. 8A and 8B, the third light emitting part LE3 may include a hole HL which exposes a portion of the third n-type semiconductor layer 305, by etching portions of the third transparent electrode layer 314, the third p-type semiconductor layer 312 and the third active layer 310. In FIG. 8A, the hole HL of the third light emitting part LE3 may be a position corresponding to at least a portion of the substrate 100 which is exposed between the first light emitting part LE1 and the second light emitting part LE2. A width W1 of the hole HL may be smaller than a width W2 of the substrate 100 which is exposed between the first light emitting part LE1 and the second light emitting part LE2. In FIG. 8B, the hole HL of the third light emitting part LE3 may be a position corresponding to at least a portion of the bonding layer BDL which is exposed between the first light emitting part LE1 and the second light emitting part LE2. A width W1 of the hole HL may be smaller than a width W2 of the bonding layer BDL which is exposed between the first light emitting part LE1 and the second light emitting part LE2.

The light emitting device may further include an adhesion part AD which bonds the first light emitting part LEI, the second light emitting part LE2 and the third light emitting part LE3 with one another among the first light emitting part LEI, the second light emitting part LE2 and the third light emitting part LE3. For instance, the adhesion part AD may be disposed to fill between the first light emitting part LE1 and the second light emitting part LE2 disposed on the substrate 100, and fill between the first and second light emitting parts LE1 and LE2 and the third light emitting part LE3. For example, the adhesion part AD may include a material such as SOG, BCB, HSQ or an SU-8 photoresist, which is transparent and has a bonding property. According to an embodiment, the light emitting device may be disposed while filling the hole HL of the third light emitting part LE3.

The light emitting device may further include a first through electrode VE1 and a first pad P1 which are electrically coupled with the first transparent electrode layer 114, a second through electrode VE2 and a second pad P2 which are electrically coupled with the second transparent electrode layer 214, and a third through electrode VE3 and a third pad P3 which are electrically coupled with the third transparent electrode layer 314. According to an example of FIG. 8A, the light emitting device may further include a fourth through electrode VE4 and a common pad CPD which electrically couple the third n-type semiconductor layer 305 and the substrate 100 and are thereby electrically coupled with the first n-type semiconductor layer 105, the second n-type semiconductor layer 205 and the third n-type semiconductor layer 305. According to another example of FIG. 8B, the light emitting device may further include a fourth through electrode VE4 and a common pad CPD which electrically couple the third n-type semiconductor layer 305 and the bonding layer BDL and are thereby electrically coupled with the first n-type semiconductor layer 105, the second n-type semiconductor layer 205 and the third n-type semiconductor layer 305.

The light emitting device may further include a passivation layer PVT which is disposed on the third n-type semiconductor layer 305, and a dielectric layer DL which surrounds the outer sidewall of each of the first through electrode VE1, the second through electrode VE2 and the third through electrode VE3.

According to an embodiment, the common pad CPD may pass through the passivation layer PVT and be brought into electrical contact with the third n-type semiconductor layer 305. The fourth through electrode VE4 which is electrically coupled with the common pad CPD may pass through the third n-type semiconductor layer 305 and be disposed in the hole HL of the third light emitting part LE3. Although the dielectric layer DL is not disposed on the outer sidewall of the fourth through electrode VE4, since the adhesion part AD which includes an insulating material is disposed in the hole HL of the third light emitting part LE3, the fourth through electrode VE4 may be insulated from the third active layer 310, the third p-type semiconductor layer 312 and the third transparent electrode layer 314 of the third light emitting part LE3. Also, as the adhesion part AD is filled between the first light emitting part LE1 and the second light emitting part LE2, the fourth through electrode VE4 which is brought into electrical contact with the substrate 100 or the bonding layer BDL may be insulated from the side surface of the first light emitting part LE1 and the side surface of the second light emitting part LE2.

Since the components and the characteristics of the light emitting devices which are not described in detail with reference to FIGS. 8A and 8B are the same as the components and the characteristics of the light emitting devices which are described above with reference to FIGS. 1A, 1B, 3A, 3B, 4A, 4B, 5A, 5B, 6, 7A and 7B, detailed descriptions thereof will be omitted herein.

Hereafter, a method for manufacturing a light emitting device in accordance with an embodiment of the disclosure will be described. In the present embodiment, a method for manufacturing the light emitting device described above with reference to FIGS. 1A and 1D will be described as an example.

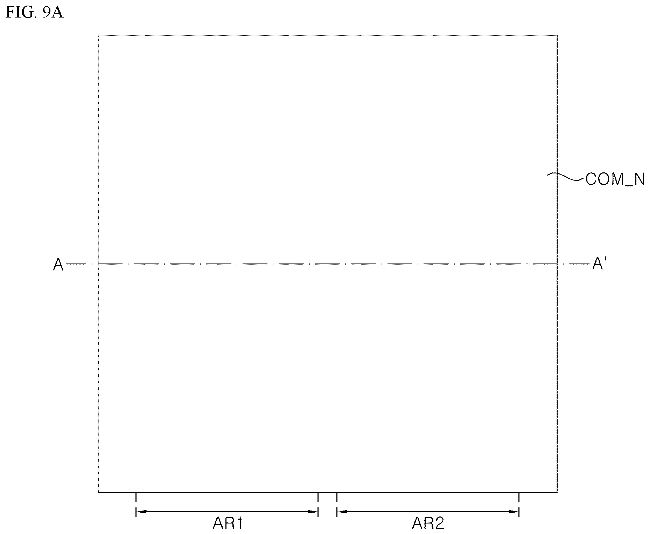

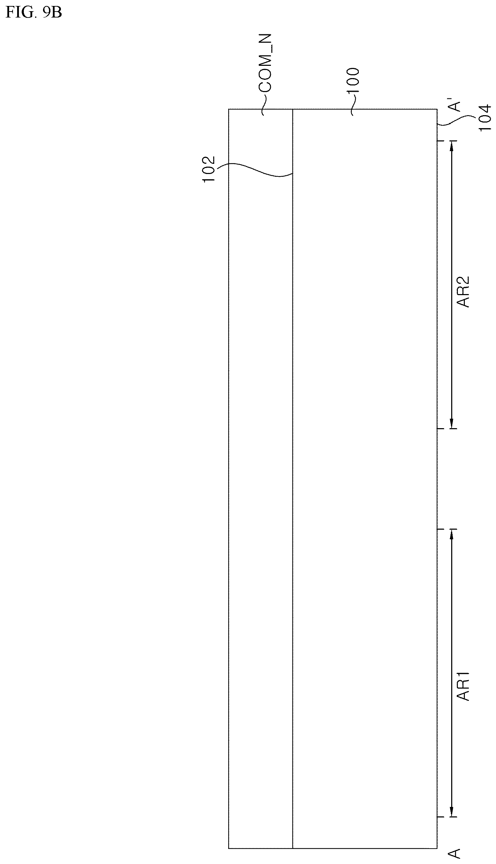

FIGS. 9A to 26A are representations of examples of top views to assist in the explanation of a method for manufacturing a light emitting device in accordance with an embodiment of the disclosure, and FIGS. 9B to 26B are cross-sectional views taken along the lines A-A' of FIGS. 9A to 26A.

Referring to FIGS. 9A and 9B, a common n-type semiconductor layer COM_N may be grown on a first substrate 100.

The first substrate 100 may include a first area AR1 where a first light emitting part LE1 is to be disposed and a second area AR2 where a second light emitting part LE2 is to be disposed.

The common n-type semiconductor layer COM_N may be formed by using a growing method such as MOCVD (metal organic chemical vapor deposition), MBE (molecular beam epitaxy), HVPE (hydride vapor phase epitaxy) and MOC (metal-organic chloride).

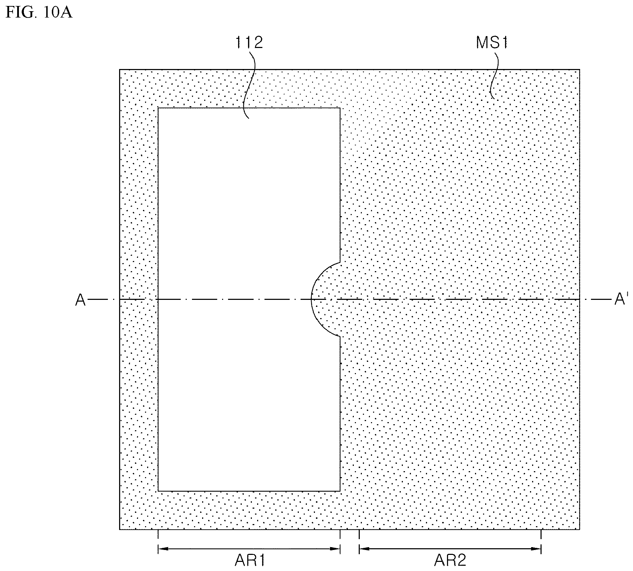

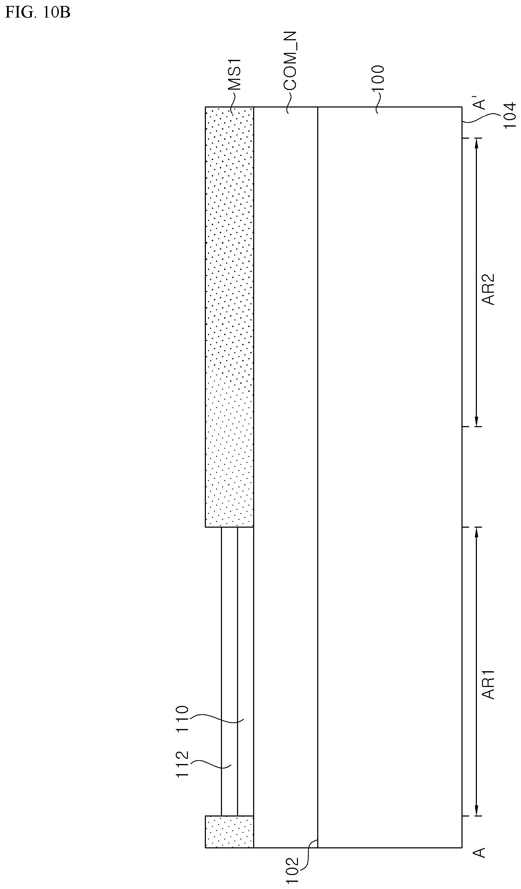

Referring to FIGS. 10A and 10B, a first mask pattern MS1 may be formed on the common n-type semiconductor layer COM_N in such a way as to expose the first area AR1 of the first substrate 100, and a first active layer 110 and a first p-type semiconductor layer 112 may be sequentially grown on the first area AR1. For instance, the first mask pattern MS1 may include SiOx or SiNx.

The first active layer 110 and the first p-type semiconductor layer 112 may be formed by using a growing method such as MOCVD, MBE, HVPE and MOC.

After forming the first active layer 110 and the first p-type semiconductor layer 112, the first mask pattern MS1 may be removed.

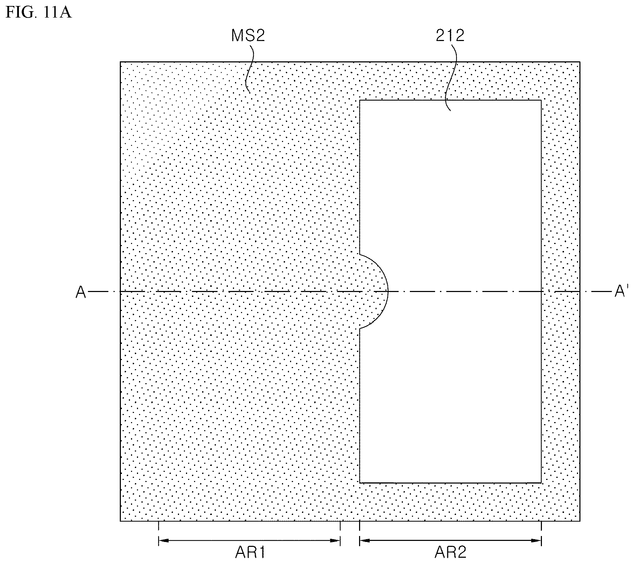

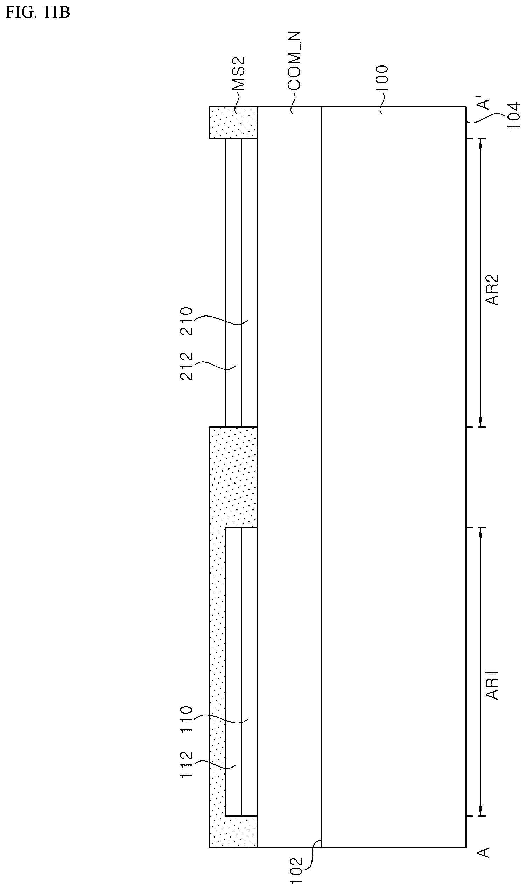

Referring to FIGS. 11A and 11B, a second mask pattern MS2 may be formed on the common n-type semiconductor layer COM_N in such a way as to expose the second area AR2 of the first substrate 100, and a second active layer 210 and a second p-type semiconductor layer 212 may be sequentially grown on the second area AR2 For instance, the second mask pattern MS2 may include SiOx or SiNx.

The second active layer 210 and the second p-type semiconductor layer 212 may be formed by using a growing method such as MOCVD, MBE, HVPE and MOC.

After forming the second active layer 210 and the second p-type semiconductor layer 212, the second mask pattern MS2 may be removed.

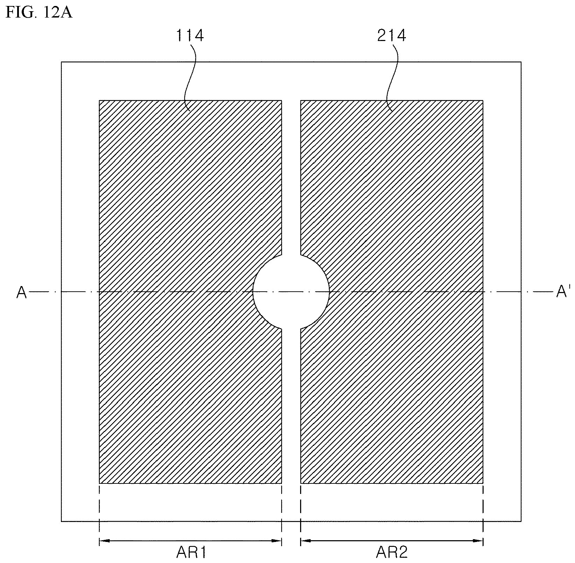

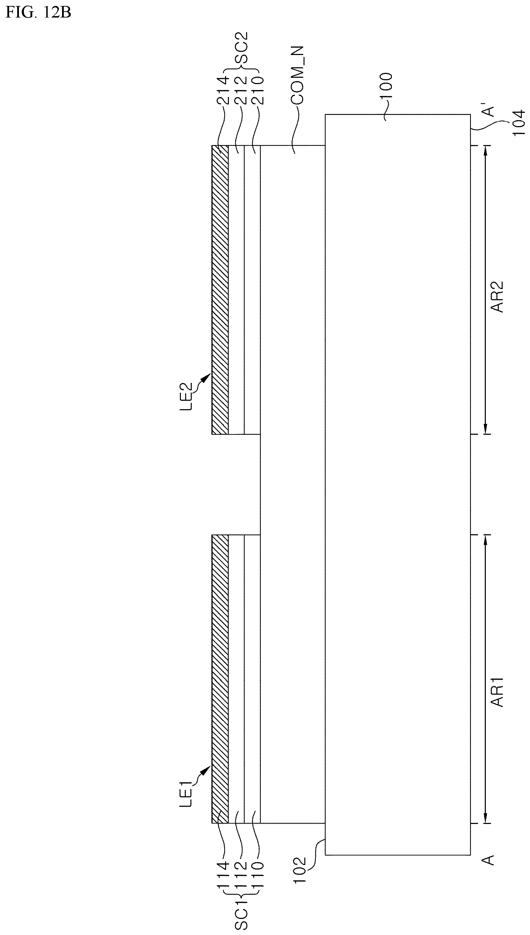

Referring to FIGS. 12A and 12B, a first transparent electrode layer 114 and a second transparent electrode layer 214 may be formed on the first p-type semiconductor layer 112 and the second p-type semiconductor layer 212, respectively.

For instance, a transparent electrode material layer may be formed on the first substrate 100 which is formed with the first p-type semiconductor layer 112 and the second p-type semiconductor layer 212, by using a deposition process generally known in the art, for example, a chemical vapor deposition (CVD) or a phsical vapor deposition (PVD) process. A third mask pattern (not shown) may be formed on the transparent electrode material layer, and, by etching the transparent electrode material layer through using the third mask pattern as an etch mask, the first transparent electrode layer 114 and the second transparent electrode layer 214 may be respectively formed. After forming the first transparent electrode layer 114 and the second transparent electrode layer 214, the third mask pattern may be removed.

By this fact, a first semiconductor structure SC1 including the first active layer 110, the first p-type semiconductor layer 112 and the first transparent electrode layer 114 and a second semiconductor structure SC2 including the second active layer 210, the second p-type semiconductor layer 212 and the second transparent electrode layer 214 may be respectively formed on the common n-type semiconductor layer COM_N.

As a consequence, the first light emitting part LE1 including the common n-type semiconductor layer COM_N and the first semiconductor structure SC1 and the second light emitting part LE2 including the common n-type semiconductor layer COM_N and the second semiconductor structure SC2 may be respectively formed on the first substrate 100.

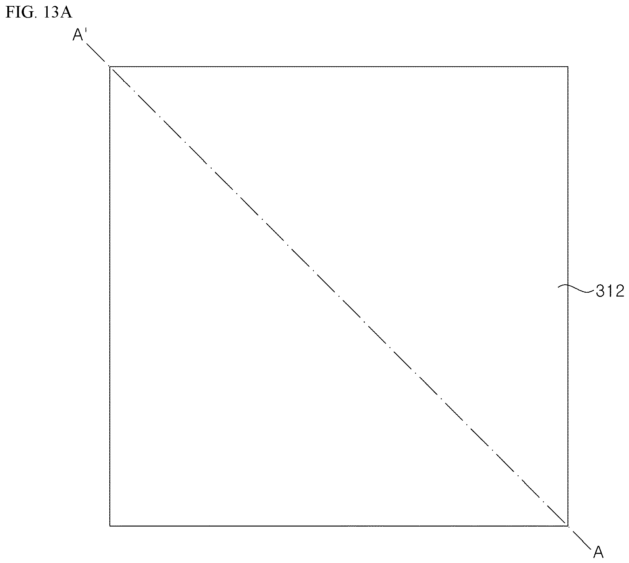

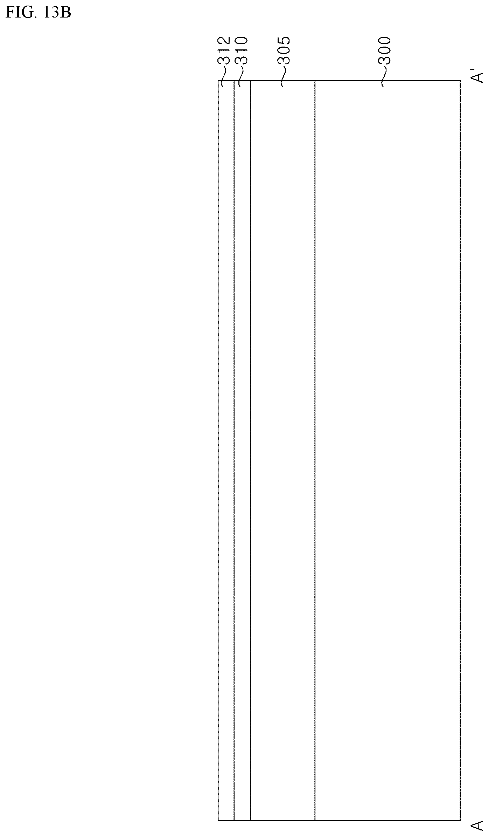

Referring to FIGS. 13A and 13B, a third n-type semiconductor layer 305, a third active layer 310 and a third p-type semiconductor layer 312 may be formed on a second substrate 300 by using a growing method such as MOCVD, MBE, HVPE and MOC.

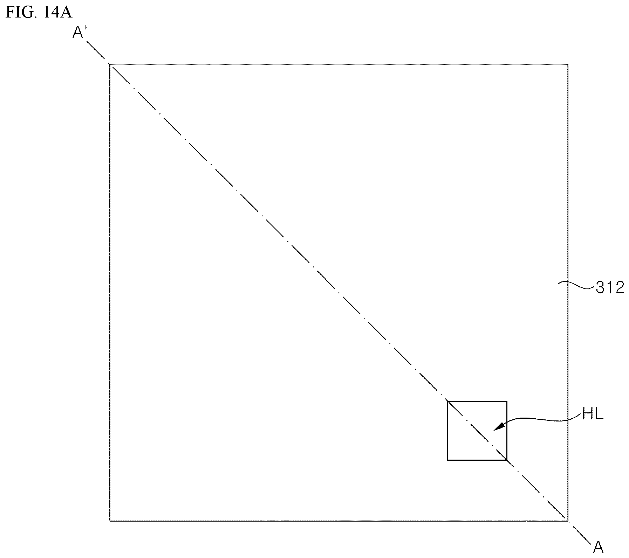

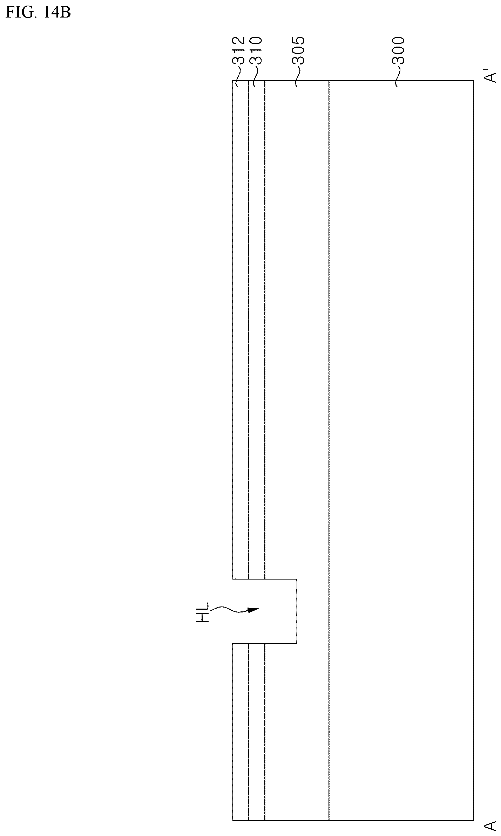

Referring to FIGS. 14A and 14B, by etching the third p-type semiconductor layer 312 and the third active layer 310, a hole HL which exposes the third n-type semiconductor layer 305 may be formed. For instance, during an etching process, a portion of the third n-type semiconductor layer 305 may be etched.

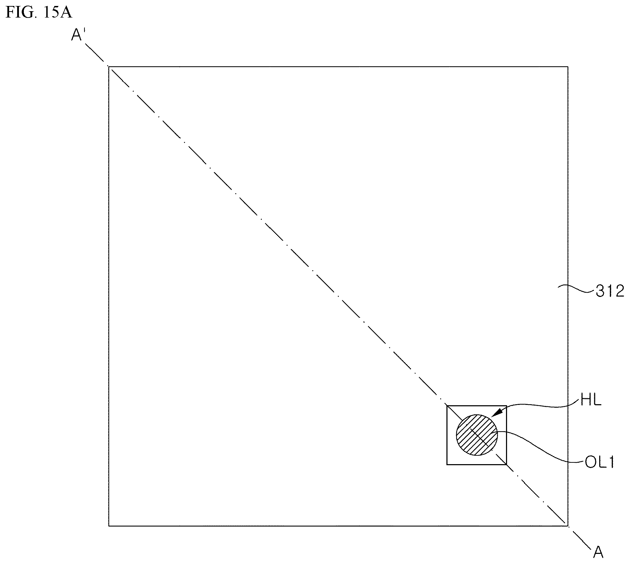

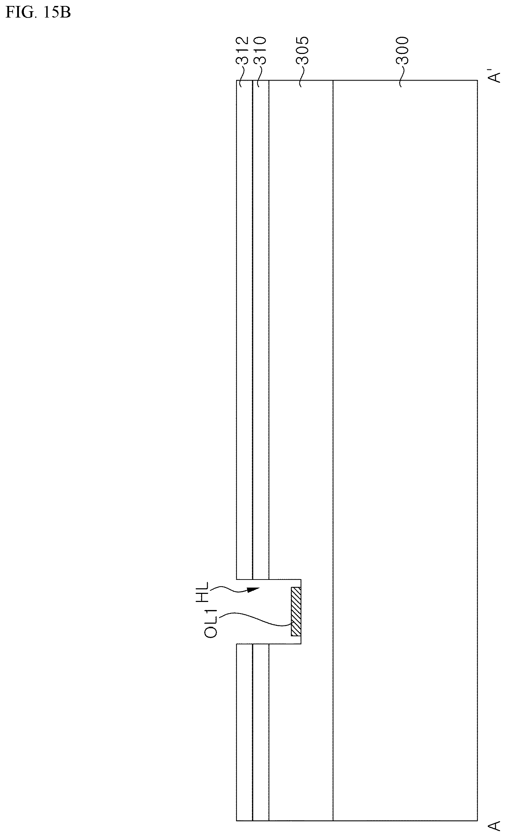

Referring to FIGS. 15A and 15B, a first ohmic pattern OL1 may be formed in the hole HL.

For instance, a first ohmic layer (not shown) may be conformally formed on the third p-type semiconductor layer 312, the third active layer 310 and the third n-type semiconductor layer 305 which are formed with the hole HL. For example, the first ohmic layer may include an Au/Be alloy. By etching the first ohmic layer such that the first ohmic layer is brought into electrical contact with the third n-type semiconductor layer 305 in the hole HL, the first ohmic pattern OL1 may be formed. After forming the first ohmic pattern OL1, annealing of 400°C or higher may be performed.

According to an embodiment, the first ohmic pattern OL1 may be formed to be separated from the third active layer 310 and the third p-type semiconductor layer 312 which form the inner sidewall of the hole HL.

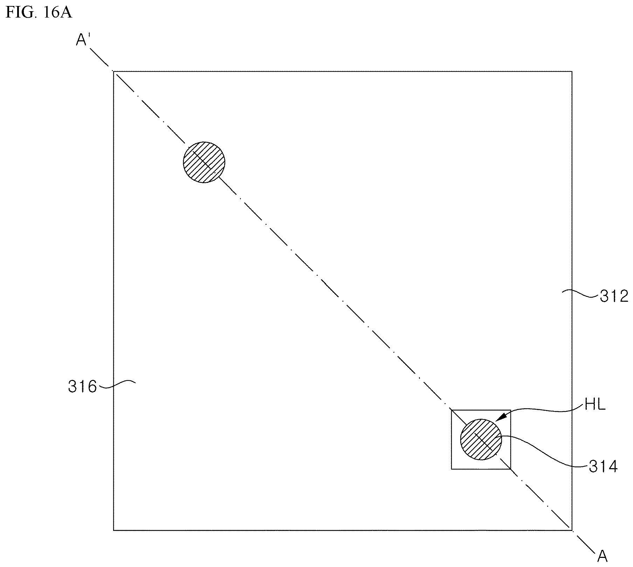

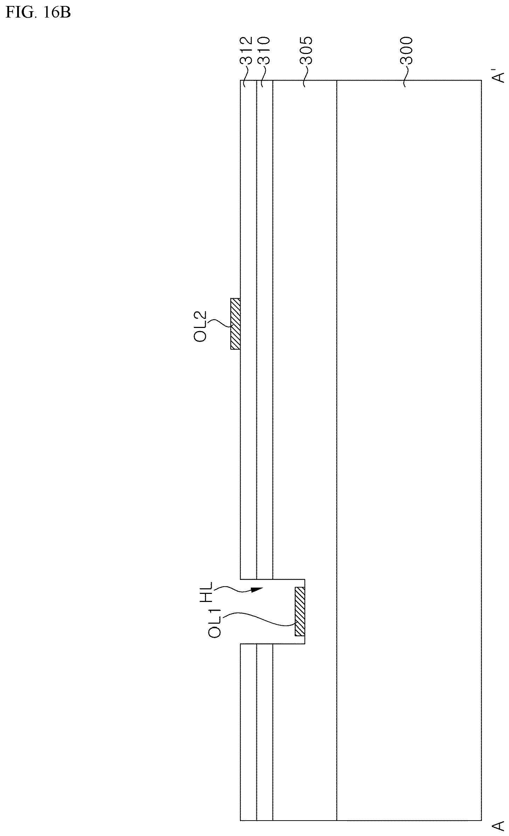

Referring to FIGS. 16A and 16B, a third ohmic pattern OL3 may be formed on the third p-type semiconductor layer 312.

For instance, a second ohmic layer (not shown) may be conformally formed on the third p-type semiconductor layer 312. For example, the second ohmic layer may include an Au/Ge alloy. By etching the second ohmic layer, the second ohmic pattern OL2 may be formed on the third p-type semiconductor layer 312. After forming the second ohmic pattern OL2, annealing of 400°C or higher may be performed.

By this fact, a third light emitting part LE3 including the third n-type semiconductor layer 305, the third active layer 310, the third p-type semiconductor layer 312, the first ohmic pattern OL1 and the second ohmic pattern OL2 may be formed.

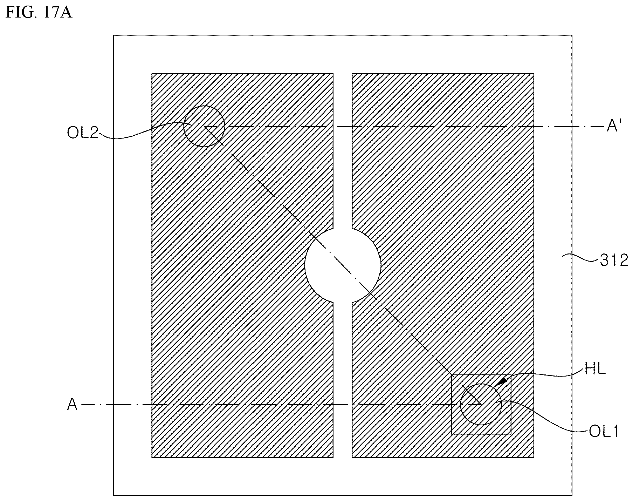

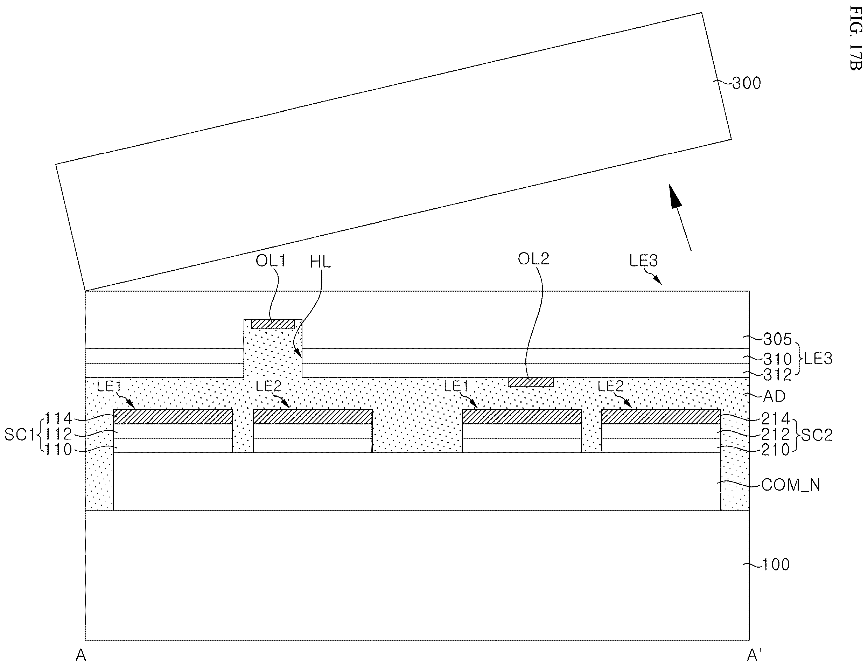

Referring to FIGS. 17A and 17B, by turning over the second substrate 300, the first ohmic pattern OL1 and the second ohmic pattern OL2 may be disposed to face the first transparent electrode layer 114 and the second transparent electrode layer 214 of the first substrate 100.

After applying an adhesion part AD on the first substrate 100 and placing the second substrate 300, by performing thermal treatment, the first light emitting part LE1 and the second light emitting part LE2 on the first substrate 100 and the third light emitting part LE3 on the second substrate 300 may be bonded with each other. The adhesion part AD may include a material which is transparent and has a bonding property, such as SOG, BCB, HSQ or an SU-8 photoresist.

In succession, the second substrate 300 may be removed through a laser lift-off (LLO) process.

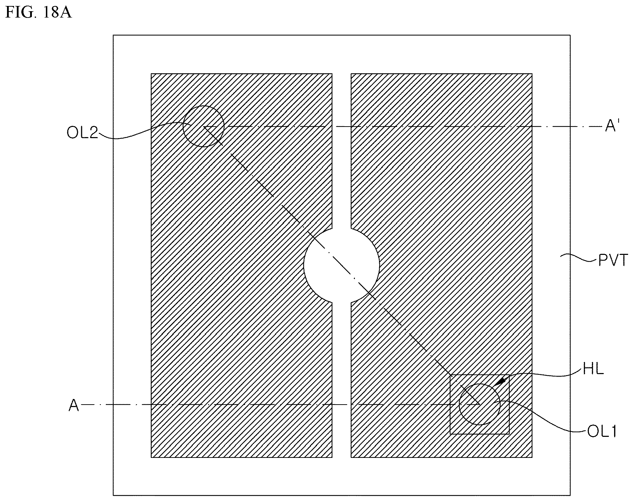

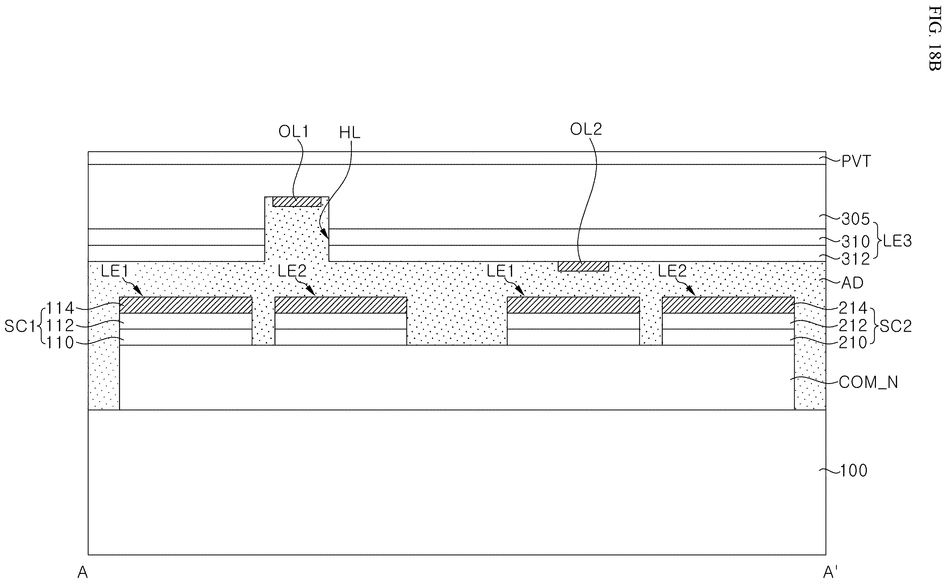

Referring to FIGS. 18A and 18B, a passivation layer PVT may be formed on the third n-type semiconductor layer 305. The passivation layer PVT may include an insulating material such as SiOx or SiNx.

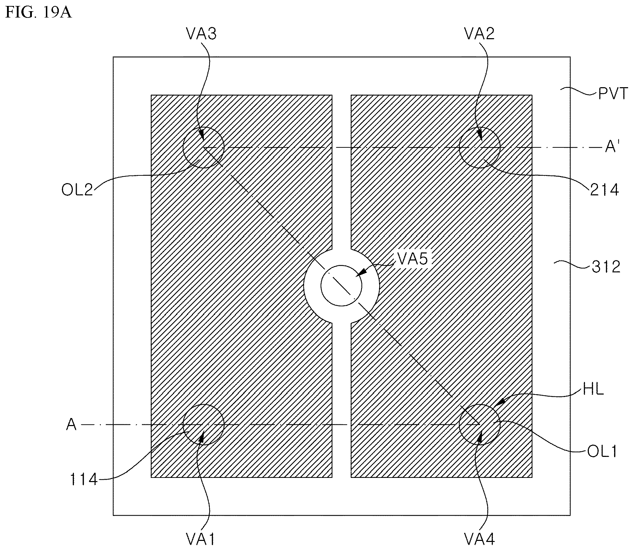

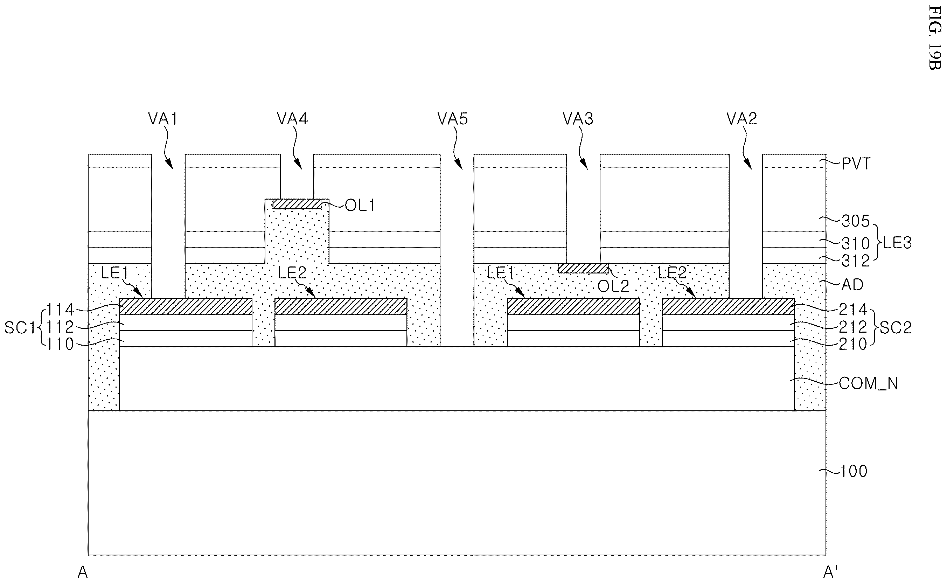

Referring to FIGS. 19A and 19B, after forming a fourth mask pattern (not shown) on the passivation layer PVT, by using the fourth mask pattern as an etch mask, a first via hole VA1 which exposes the first transparent electrode layer 114, a second via hole VA2 which exposes the second transparent electrode layer 214, a third via hole VA3 which exposes the second ohmic pattern OL2, a fourth via hole VA4 which exposes the first ohmic pattern OL1 and a fifth via hole VA5 which exposes the common n-type semiconductor layer COM_N may be formed.

For instance, in the case where the substrate 100 is quadrangular, the first via hole VA1, the second via hole VA2, the third via hole VA3 and the fourth via hole VA4 may be formed at the corners of the substrate 100, and the fifth via hole VA5 may be formed at the center of the substrate 100.

The fourth mask pattern MS4 may include a photoresist. After forming the first via hole VA1, the second via hole VA2, the third via hole VA3, the fourth via hole VA4 and the fifth via hole VA5, the fourth mask pattern may be removed.

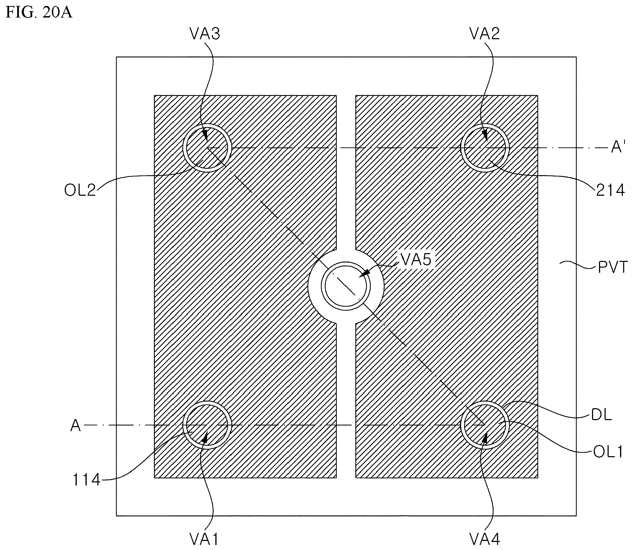

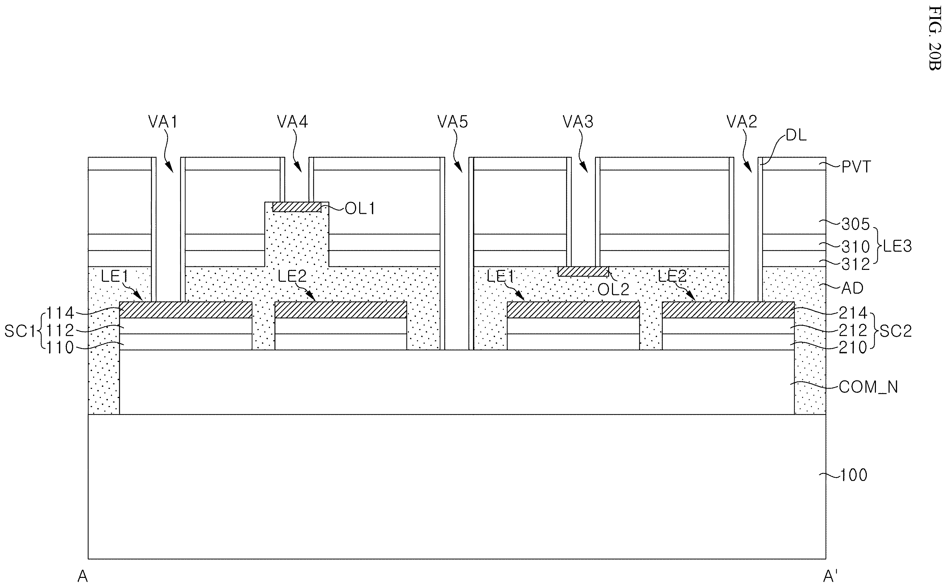

Referring to FIGS. 20a and 20b, a dielectric layer DL may be conformally formed on the first light emitting part LEI, the second light emitting part LE2 and the third light emitting part LE3 which are formed with the first via hole VA1, the second via hole VA2, the third via hole VA3, the fourth via hole VA4 and the fifth via hole VA5, by using an atomic layer deposition (ALD) process or a plasma enhanced CVD (PECVD) process. The dielectric layer DL may include a material which has an etching selectivity with respect to the passivation layer PVT for an etchant. For example, in the case where the passivation layer PVT includes SiOx, the dielectric layer DL may include at least one selected from the group consisting of SiNx, TiNx, TiOx, TaOx, ZrOx and HfOx.

In succession, by anisotropically etching the dielectric layer DL without a mask, the dielectric layer DL which is formed on the passivation layer PVT and the bottoms of the first via hole VA1, the second via hole VA2, the third via hole VA3, the fourth via hole VA4 and the fifth via hole VA5 may be etched, and the dielectric layer DL may remain on the inner sidewall of each of the first via hole VA1, the second via hole VA2, the third via hole VA3, the fourth via hole VA4 and the fifth via hole VA5.

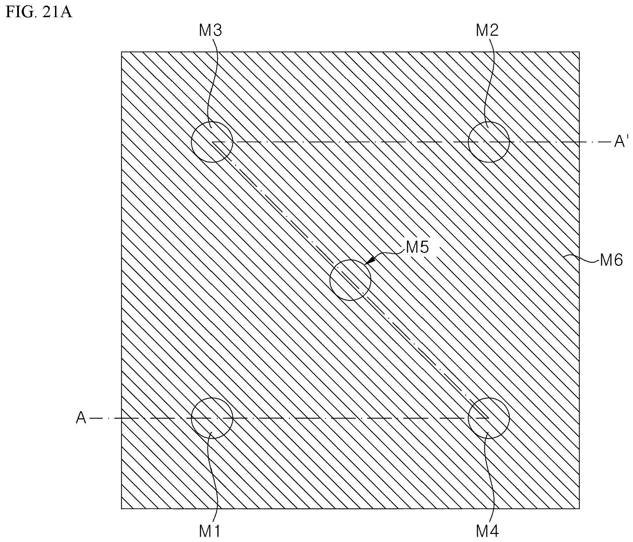

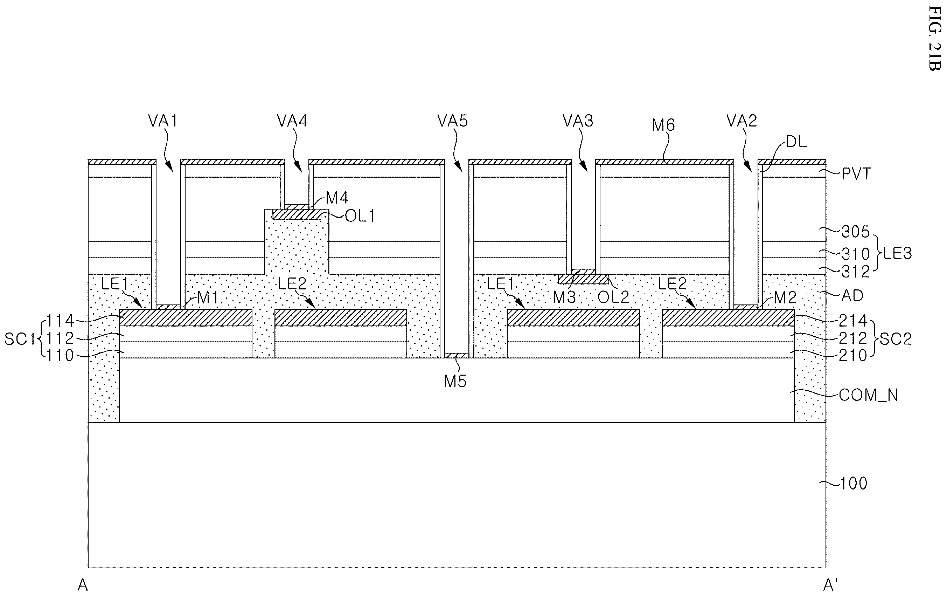

Referring to FIGS. 21A and 21B, metal patterns may be formed on the bottoms of the first via hole VA1, the second via hole VA2, the third via hole VA3, the fourth via hole VA4 and the fifth via hole VA5 which are formed with the dielectric layer DL and on the passivation layer PVT, by using an anisotropic deposition process such as a sputtering process. Each of the metal patterns may include a Cr/Al, Cr/Au, or Ti/Al alloy.

The metal patterns may include a first metal pattern M1 which is formed on the bottom of the first via hole VA1, a second metal pattern M2 which is formed on the bottom of the second via hole VA2, a third metal pattern M3 which is formed on the bottom of the third via hole VA3, a fourth metal pattern M4 which is formed on the bottom of the fourth via hole VA4, a fifth metal pattern M5 which is formed on the bottom of the fifth via hole VA5 and a sixth metal pattern M6 which is formed on the passivation layer PVT.

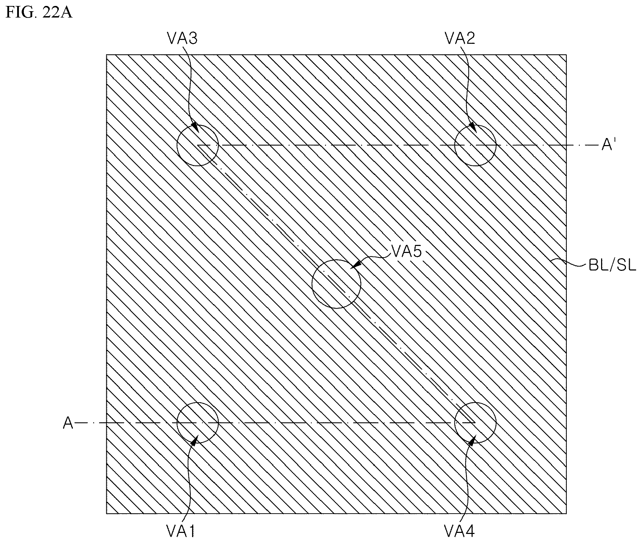

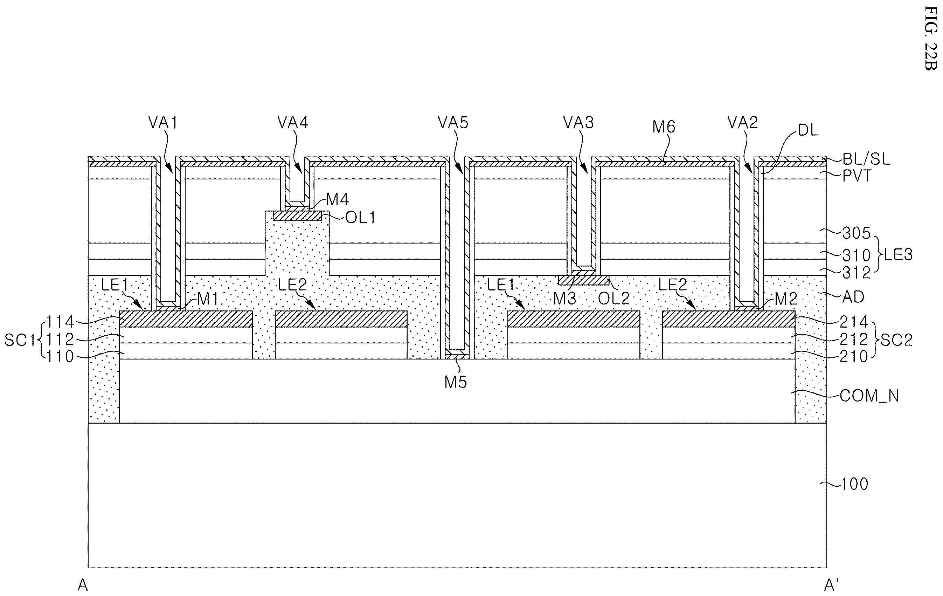

Referring to FIGS. 22A and 22B, a buffer layer BL and a seed layer SL may be sequentially formed conformally on the first light emitting part LEI, the second light emitting part LE2 and the third light emitting part LE3 which are formed with the first metal pattern M1, the second metal pattern M2, the third metal pattern M3, the fourth metal pattern M4, the fifth metal pattern M5 and the sixth metal pattern M6. The buffer layer BL may include a Ta alloy, a TiW alloy or a TiNi alloy. The seed layer SL may include Cu. According to an embodiment, the buffer layer BL and the seed layer SL may be conformally formed while not burying the first via hole VA1, the second via hole VA2, the third via hole VA3, the fourth via hole VA4 and the fifth via hole VA5 which are formed with the first metal pattern M1, the second metal pattern M2, the third metal pattern M3, the third metal pattern M3, the fourth metal pattern M4 and the fifth metal pattern M5, respectively.

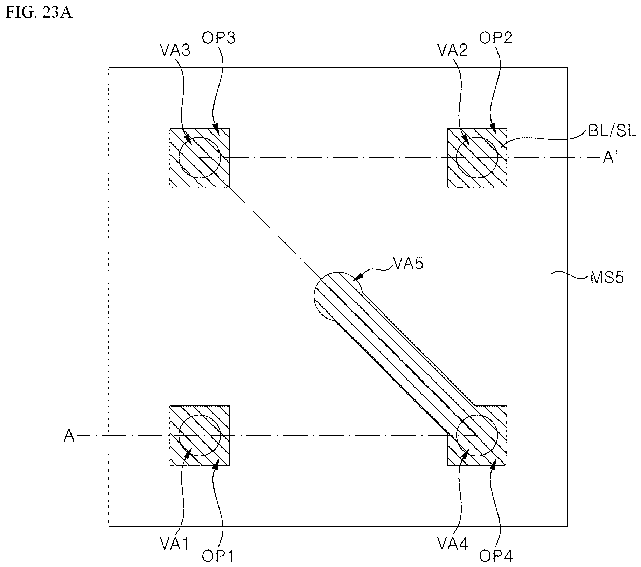

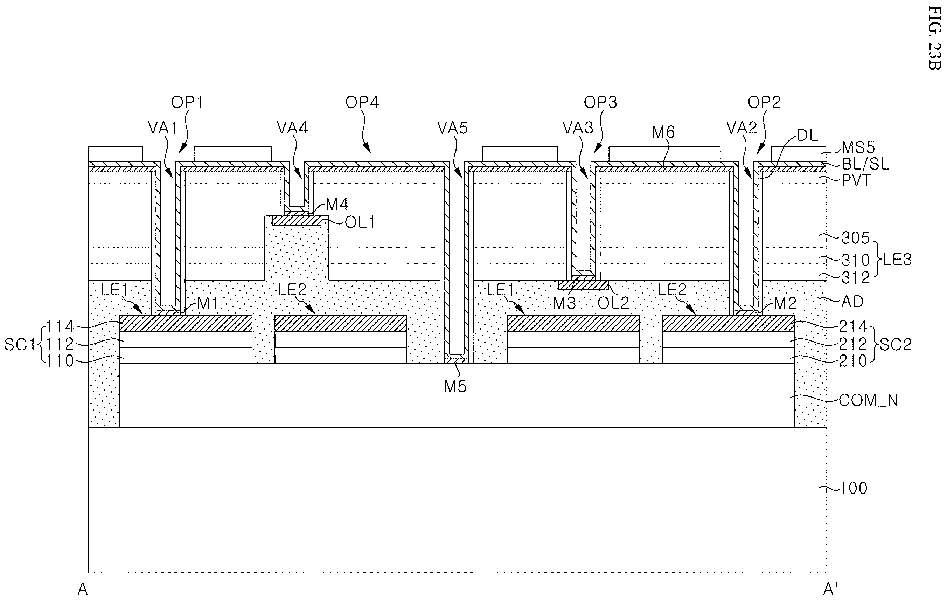

Referring to FIGS. 23A and 23B, a fifth mask pattern MS5 may be formed on the seed layer SL. The fifth mask pattern MS5 may include a photoresist. The fifth mask pattern MS5 may include openings which expose the first via hole VA1, the second via hole VA2, the third via hole VA3, the fourth via hole VA4 and the fifth via hole VA5 which are formed with the seed layer SL.

The openings may include a first opening OP1 which exposes the first via hole VA1, a second opening OP2 which exposes the second via hole VA2, a third opening OP3 which exposes the third via hole VA3 and a fourth opening OP4 which exposes together the fourth via hole VA4 and the fifth via hole VA5.

For instance, in the case where the first via hole VA1, the second via hole VA2, the third via hole VA3 and the fourth via hole VA4 are formed at the corners of the substrate 100 and the fifth via hole VA5 is formed at the center of the substrate 100, the first opening OP1, the second opening OP2 and the third opening OP3 may be respectively formed at the corners of the substrate 100, and the fourth opening OP4 may have a structure which extends from one corner to the center of the substrate 100.

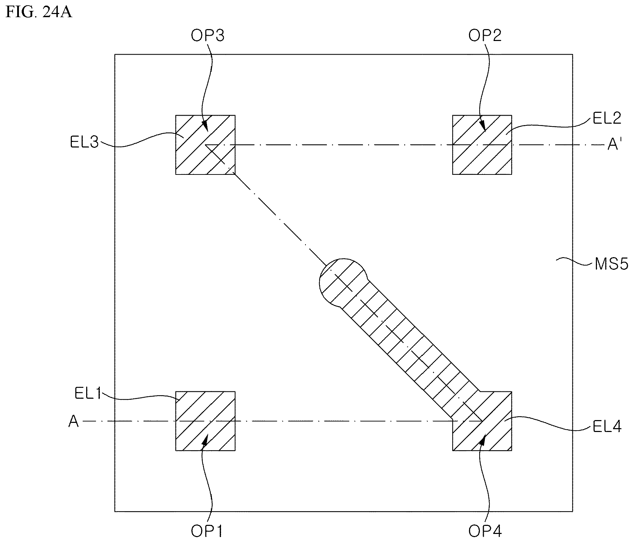

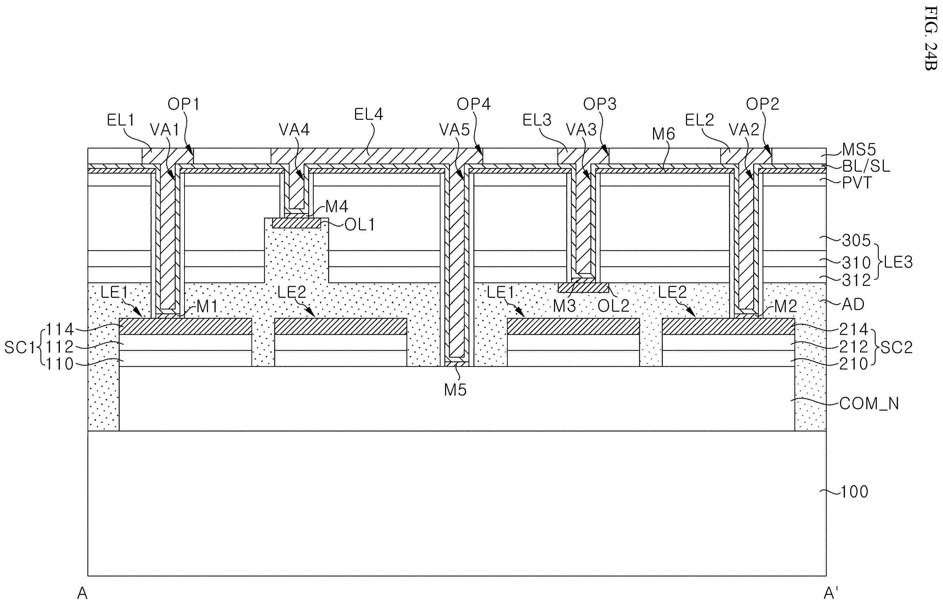

Referring to FIGS. 24A and 24B, through a plating process using the seed layer SL, electrode layers which bury the first via hole VA1, the second via hole VA2, the third via hole VA3, the fourth via hole VA4 and the fifth via hole VA5 and fill the first opening OP1, the second opening OP2, the third opening OP3 and the fourth opening OP4 may be respectively formed.

The electrode layers may include a first electrode layer EL1 which fills the first via hole VA1 and the first opening OP1, a second electrode layer EL2 which fills the second via hole VA2 and the second opening OP2, a third electrode layer EL3 which fills the third via hole VA3 and the third opening OP3, and a fourth electrode layer EL4 which fills the fourth via hole VA4, the fifth via hole VA5 and the fourth opening OP4.

Selectively, since the electrode layers EL1, EL2, EL3 and EL4 are formed through a plating process, they may be formed to be higher than the fifth mask pattern MS5. Thus, by processing the top surfaces of the electrode layers EL1, EL2, EL3 and EL4 through using a polishing process such as a chemical mechanical polishing (CMP) process, each of the electrode layers EL1, EL2, EL3 and EL4 may have a top surface at the same level as the surface of the fifth mask pattern MS5.

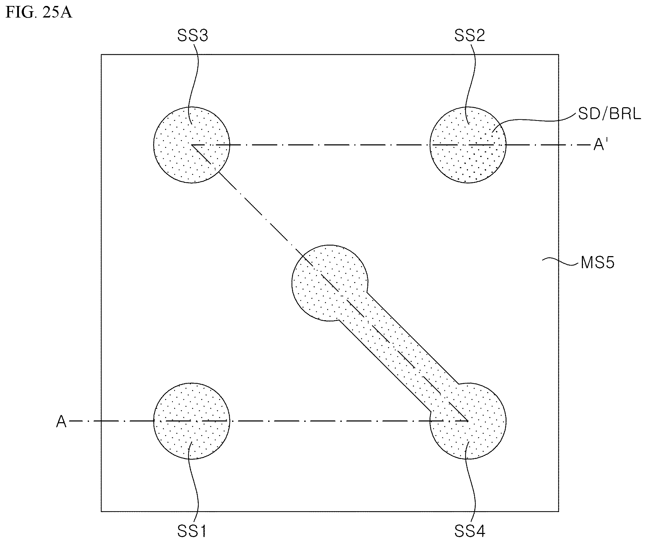

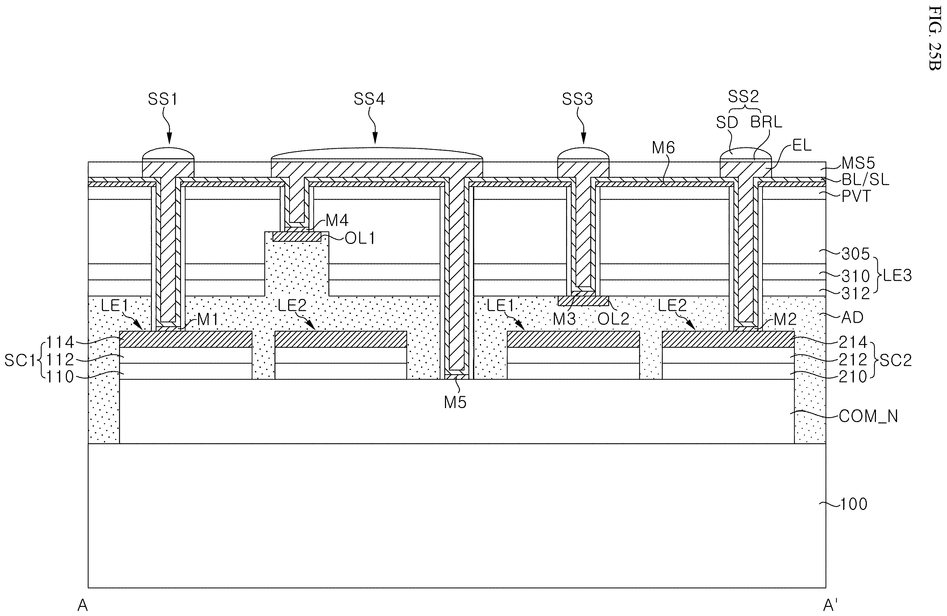

Referring to FIGS. 25A and 25B, solder structures may be formed on the electrode layers EL1, EL2, EL3 and EL4, respectively.

The solder structures may be respectively formed on areas which are defined by the fifth mask pattern MS5, that is, on the electrode layers EL1, EL2, EL3 and EL4. The solder structures may include a first solder structure SS1 which is formed on the first electrode layer EL1, a second solder structure SS2 which is formed on the second electrode layer EL2, a third solder structure SS3 which is formed on the third electrode layer EL3 and a fourth solder structure SS4 which is formed on the fourth electrode layer EL4.

According to an embodiment, in the solder structures SS1, SS2, SS3 and SS4, solder balls SD which include In may be respectively formed through a plating process. A barrier layer BRL which includes Ni, Ti, Cr, or others may be formed before forming the solder balls SD.

Selectively, the process of forming the solder structures SS1, SS2, SS3 and SS4 may be omitted.

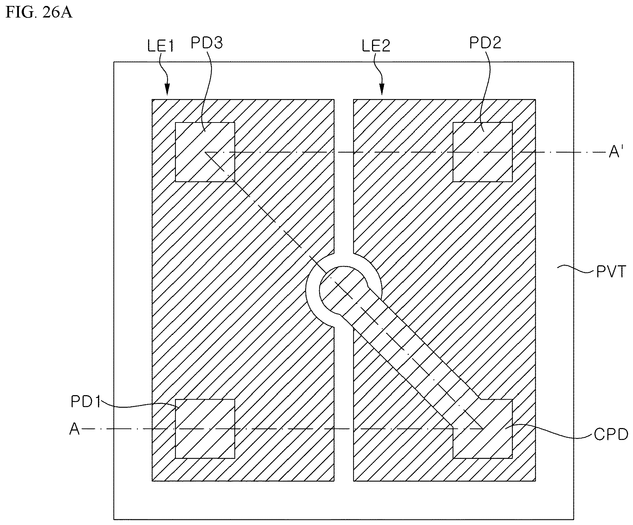

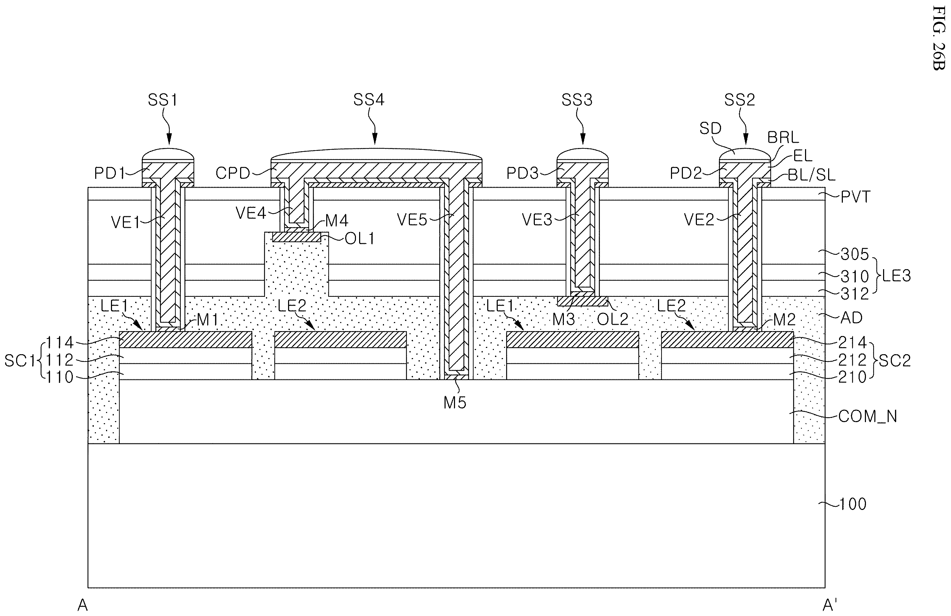

Referring to FIGS. 26A and 26B, after removing the fifth mask pattern MS5, by etching the seed layer SL and the sixth metal pattern M6, a first through electrode VE1, a first pad PD1, a second through electrode VE2, a second pad PD2, a third through electrode VE3, a third pad PD3, a fourth through electrode VE4, a fifth through electrode VE5 and a common pad CPD may be formed.

The first through electrode VE1 may bury the first via hole VA1 and include the barrier layer BL, the seed layer SL and the first electrode layer EL1, and the first pad PD1 may extend from the first through electrode VE1, bury the first opening OP1 and include the barrier layer BL, the seed layer SL and the first electrode layer EL. The second through electrode VE2 may bury the second via hole VA2 and include the barrier layer BL, the seed layer SL and the second electrode layer EL2, and the second pad PD2 may extend from the second through electrode VE2, bury the second opening OP2 and include the barrier layer BL, the seed layer SL and the second electrode layer EL2. The third through electrode VE3 may bury the third via hole VA3 and include the barrier layer BL, the seed layer SL and the third electrode layer EL3, and the third pad PD3 may extend from the third through electrode VE3, bury the third opening OP3 and include the barrier layer BL, the seed layer SL and the third electrode layer EL3. The fourth through electrode VE4 may bury the fourth via hole VA4 and include the barrier layer BL, the seed layer SL and the fourth electrode layer EL4; the fifth through electrode VE5 may bury the fifth via hole VA5 and include the barrier layer BL, the seed layer SL and the fourth electrode layer EL4; and the common pad CPD may extend from the fourth through electrode VE4 and the fifth through electrode VE5, bury the fourth opening OP4 and include the barrier layer BL, the seed layer SL and the fourth electrode layer EL4.

In the case where the solder structures SS1, SS2, SS3 and SS4 are not formed in the processes described above with reference to FIGS. 9A to 26A and 9B to 26B, the light emitting device shown in FIG. 1B may be completed. Unlike this, in the case where the solder structures SS1, SS2, SS3 and SS4 are formed in the processes described above with reference to FIGS. 9A to 26A and 9B to 26B, the light emitting device shown in FIG. ID may be completed.

Meanwhile, alternatively, the processes for forming the first through electrode VE1, the second through electrode VE2, the third through electrode VE3, the fourth through electrode VE4, the fifth through electrode VE5, the first pad PD1, the second pad PD2, the third pad PD3 and the common pad CPD may be performed as processes to be described below.

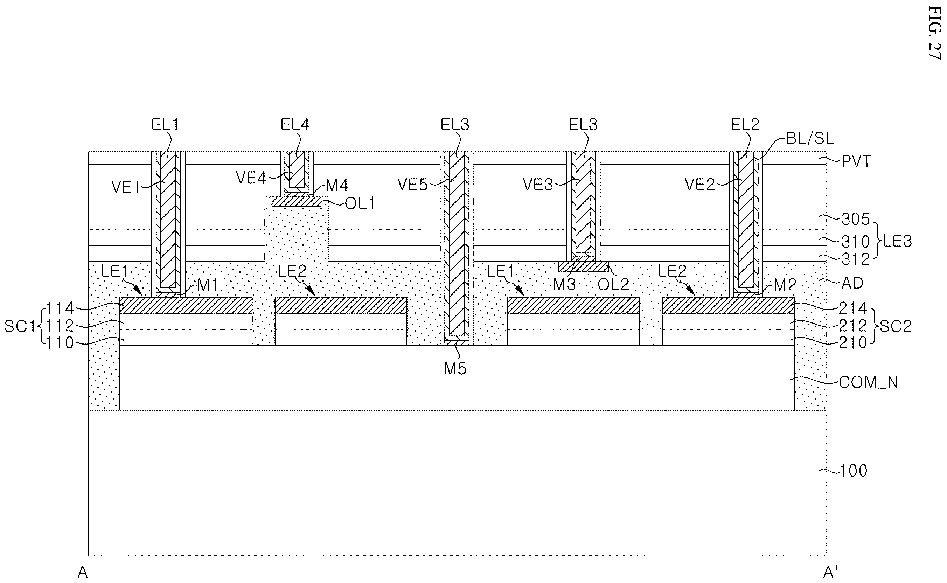

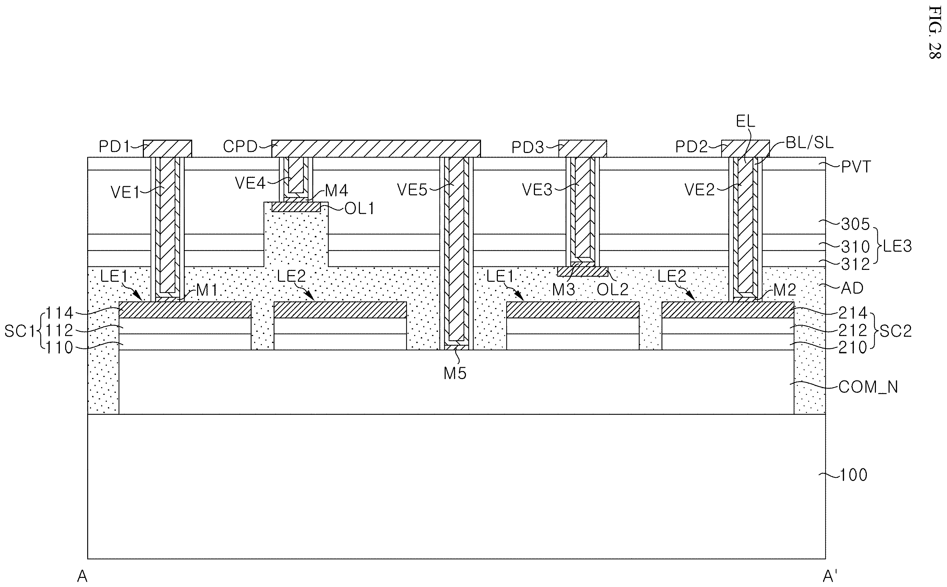

FIGS. 27 and 28 are representations of examples of cross-sectional views to assist in the explanation of a method for manufacturing a light emitting device in accordance with another embodiment of the disclosure.

As described above with reference to FIGS. 9A to 24A and 9B to 24B, the first light emitting part LEI, the second light emitting part LE2, the adhesion part AD, the third light emitting part LE3, the passivation layer PVT, the barrier layer BL, the seed layer SL, the first electrode layer EL1 which fills the first via hole VA1, the second electrode layer EL2 which fills the second via hole VA2, the third electrode layer EL3 which fills the third via hole VA3 and the fourth electrode layer EL4 which fills the fourth via hole VA4 and fifth electrode layer EL5 which fills the fifth via hole VA5 may be formed.

Referring to FIG. 27, by etching or polishing the first electrode layer EL1, the second electrode layer EL2, the third electrode layer EL3, the fourth electrode layer EL4, the fifth electrode layer EL5, the fifth mask pattern MS5, the seed layer SL and the barrier layer BL, a first through electrode VE1, a second through electrode VE2, a third through electrode VE3, a fourth through electrode VE4 and a fifth electrode layer EL5 may be respectively formed.

In this case, the passivation layer PVT may serve as an etch (or polish) stopper in the process of etching or polishing the first electrode layer EL1, the second electrode layer EL2, the third electrode layer EL3, the fourth electrode layer EL4, the fifth mask pattern MS5, the seed layer SL and the barrier layer BL.

Referring to FIG. 28, a first pad PD1 which is electrically coupled with the first through electrode VE1, a second pad PD2 which is electrically coupled with the second through electrode VE2, a third pad PD3 which is electrically coupled with the third through electrode VE3 and a common pad CPD which is electrically coupled with the fourth through electrode VE4 and the fifth through electrode VE5 may be respectively formed on the passivation layer PVT.

In the case of using the processes of FIGS. 27 and 28, the light emitting device shown in FIG. 1C may be completed.

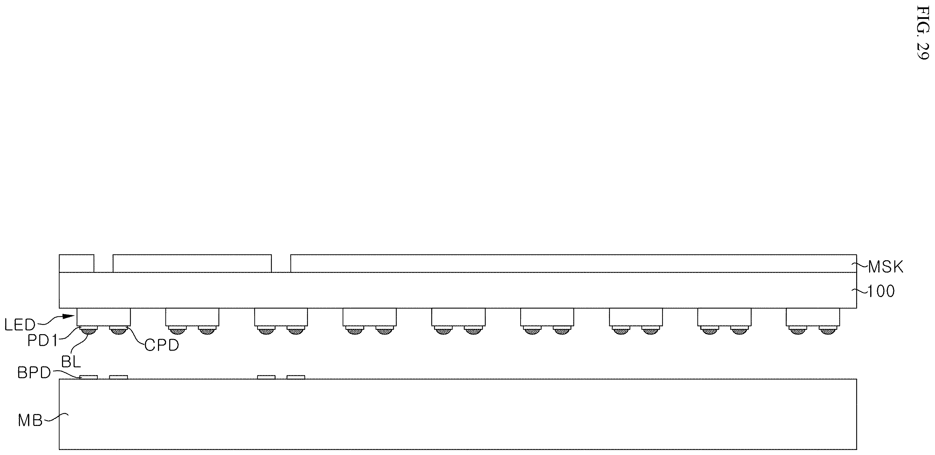

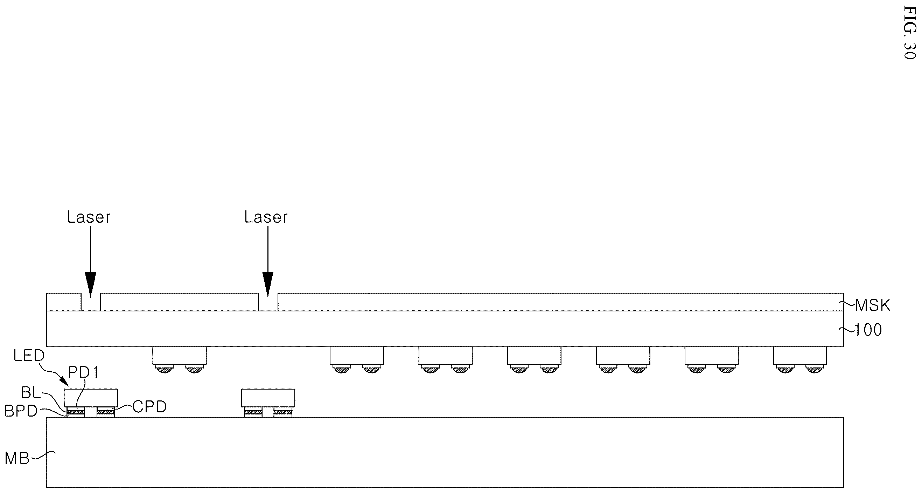

FIGS. 29 and 30 are representations of examples of cross-sectional views to assist in the explanation of a method for mounting light emitting devices to a mounting board 100 in accordance with an embodiment of the disclosure.

Referring to FIG. 29, a plurality of light emitting devices LEDs which are formed through FIGS. 9A to 26A and 9B to 26B may be mounted to a target mounting board MB

Bonding pads BPD which are to be electrically bonded with the first pad PD1, the second pad PD2, the third pad PD3 and the common pad CPD, respectively, may be formed on the mounting board MB The bonding pads BPD may be formed to correspond to positions where the light emitting devices LEDs are to be mounted.

For instance, the solder structures SS1, SS2, SS3 and SS4 may be formed on the first pad PD1, the second pad PD2, the third pad PD3 and the common pad CPD, respectively. For another instance, solder structures may be respectively formed on the bonding pads BPD of the mounting board 100.

The first substrate 100 which is formed with the plurality of light emitting devices LED may be turned over, and thus, the light emitting devices LEDs may be positioned to face the mounting board MB which is formed with the bonding pads BPD.

A mask pattern MSK which exposes light emitting devices LEDs to be separated from the first substrate 100 may be formed on the turned-over first substrate 100.

Referring to FIG. 30, by performing a selective laser lift-off (LLO) process for the first substrate 100 through using the mask pattern MSK, the light emitting devices LEDs which are disposed to face target mounting positions of the mounting board MB may be separated from the first substrate 100. A separation distance between the separated light emitting devices LEDs may be changed depending on the mounting board MB, and in order to prevent the light emitting devices LEDs from falling off, the selective LLO may be performed after the light emitting devices LEDs are bonded to the mounting board MB, whereby the light emitting devices LEDs cna be more stably mounted at desired positions. In an embodiment, the mask pattern MSK defining laser incident positions may be omitted in the selective LLO process.

The first pad PD1, the second pad PD2, the third pad PD3 and the common pad CPD of each of the separated light emitting devices LEDs may be respectively bonded with the bonding pads BPD by the solder structures SS1, SS2, SS3 and SS4. By this fact, the light emitting devices LEDs may be mounted to the mounting board MB

If all the light emitting devices LEDs are mounted at the target positions, the first substrate 100 may be separated from the light emitting devices LEDs without separately performing a process for removing the first substrate 100.

While various embodiments have been described above, it will be understood to those skilled in the art that the embodiments described are by way of example only. Accordingly, the disclosure described herein should not be limited based on the described embodiments.

## Claims

1. A light emitting device comprising:
a first light emitting part having a first area;
a second light emitting part having a second area; and
a third light emitting part having a third area,
wherein the first light emitting part is disposed on the same plane as the second light emitting part,
wherein the third light emitting part is disposed over the first and second light emitting parts, and
wherein the third area is larger than each of the first and second areas.

2. The light emitting device according to claim 1,
wherein the first light emitting part includes a first first-conductivity type semiconductor layer, and a first semiconductor structure including a first active layer and a first second-conductivity type semiconductor layer disposed on the first first-conductivity type semiconductor layer,
wherein the second light emitting part includes the first first-conductivity type semiconductor layer, and a second semiconductor structure which is disposed on the first first-conductivity type semiconductor layer to be separated from the first semiconductor structure and includes a second active layer and a second second-conductivity type semiconductor layer, and
wherein the third light emitting part is disposed to be separated from the first and second light emitting parts and includes a third first-conductivity type semiconductor layer, a third active layer and a third second-conductivity type semiconductor layer.

3. The light emitting device according to claim 2, further comprising:
a first pad electrically coupled with the first second-conductivity type semiconductor layer;
a second pad electrically coupled with the second second-conductivity type semiconductor layer;
a third pad electrically coupled with the third second-conductivity type semiconductor layer; and
a common pad electrically coupling in common the first first-conductivity type semiconductor layer and the third first-conductivity type semiconductor layer.

4. The light emitting device according to claim 3, further comprising:
a first through electrode electrically coupling the first second-conductivity type semiconductor layer and the first pad;
a second through electrode electrically coupling the second second-conductivity type semiconductor layer and the second pad;
a third through electrode electrically coupling the third second-conductivity type semiconductor layer and the third pad;
a fourth through electrode electrically coupling the first first-conductivity type semiconductor layer which is exposed between the first and second semiconductor structures and the common pad; and
a fifth through electrode electrically coupling the third first-conductivity type semiconductor layer and the common pad.

5. The light emitting device according to claim 3, further comprising:
a first through electrode electrically coupling the first second-conductivity type semiconductor layer and the first pad;
a second through electrode electrically coupling the second second-conductivity type semiconductor layer and the second pad;
a third through electrode electrically coupling the third second-conductivity type semiconductor layer and the third pad; and
a fourth through electrode electrically coupling the first and third first-conductivity type semiconductor layers and the common pad,
wherein the fourth through electrode passes through the third first-conductivity type semiconductor layer and is electrically connected to the first first-conductivity type semiconductor layer exposed between the first and second semiconductor structures..

6. The light emitting device according to claim 5, further comprising:
an adhesion part filling between the first and second light emitting parts and the third light emitting part and between the first and second semiconductor structures, and bonding the first and second light emitting parts and the third light emitting part.

7. The light emitting device according to claim 6, further comprising:
a dielectric layer surrounding outer sidewalls of the first to fourth through patterns,
wherein the fourth through pattern passes through the third light emitting part and the adhesion part, one surface of the fourth through pattern is brought into contact with the first first-conductivity type semiconductor layer which is exposed between the first and second semiconductor structures, and the other surface of the fourth through pattern is brought into contact with the common pad, and
wherein the common pad is brought into electrical contact with the third first-conductivity type semiconductor layer.

8. The light emitting device according to claim 6,
wherein the third light emitting part includes a hole which exposes the third first-conductivity type semiconductor layer, and
wherein the hole has a width smaller than a width of the first first-conductivity type semiconductor layer which is exposed between the first and second semiconductor structures, at a position corresponding to the first first-conductivity type semiconductor layer which is exposed between the first and second semiconductor structures.

9. The light emitting device according to claim 8,
wherein the hole is disposed between third first-conductivity type semiconductor layer and the first first-conductivity type semiconductor layer, and the adhesion part fills the hole, and
wherein the fourth through pattern passes through the third first-conductivity type semiconductor layer and the adhesion part, one surface of the fourth through pattern is brought into contact with the common pad, the other surface facing away from the one surface is brought into contact with the first first-conductivity type semiconductor layer, and a sidewall of the fourth through pattern is brought into contact with the third first-conductivity type semiconductor layer.

10. The light emitting device according to claim 8, further comprising:
a dielectric layer filling the hole,
wherein the hole is disposed between the common pad and the third first-conductivity type semiconductor layer, and
wherein the fourth through pattern passes through the dielectric layer and the third first-conductivity type semiconductor layer, an upper sidewall of the fourth through pattern is brought into contact with the dielectric layer, a middle sidewall of the fourth through pattern is brought into contact with the third first-conductivity type semiconductor layer, a lower sidewall of the fourth through pattern is brought into contact with the bonding part, one surface of the fourth through pattern is brought into contact with the common pad, and the other surface facing away from the one surface is brought into contact with the first first-conductivity type semiconductor layer which is exposed between the first and second semiconductor structures.

11. The light emitting device according to claim 6,
wherein the third light emitting part includes a hole which exposes the third first-conductivity type semiconductor layer, and
wherein the hole has a width smaller than a width of the first first-conductivity type semiconductor layer which is exposed between the first and second semiconductor structures, at a position corresponding to the first first-conductivity type semiconductor layer which is exposed between the first and second semiconductor structures.

12. The light emitting device according to claim 11,
wherein the hole faces the first first-conductivity type semiconductor layer which is exposed between the first and second semiconductor structures, and
wherein the adhesion part extends into the hole and is brought into contact with the third first-conductivity type semiconductor layer, and extends between the first and second semiconductor structures and is brought into contact with the first first-conductivity type semiconductor layer.

13. The light emitting device according to claim 12, wherein the fourth through pattern is brought into contact with at least portions of the third first-conductivity type semiconductor layer and the adhesion part.

14. The light emitting device according to claim 13, wherein the fourth through pattern passes through the third first-conductivity type semiconductor layer, and a sidewall of the fourth through pattern is brought into contact with the third first-conductivity type semiconductor layer.

15. The light emitting device according to claim 11, further comprising:
a dielectric layer filling the hole,
wherein the hole is disposed between the common pad and the third first-conductivity type semiconductor layer, and
wherein the fourth through pattern passes through the dielectric layer and passes through at least portions of the third first-conductivity type semiconductor layer and the adhesion part, and a portion of the fourth through pattern is brought into contact with the third first-conductivity type semiconductor layer.

16. The light emitting device according to claim 1, further comprising:
a substrate on which the first and second light emitting parts are disposed to be separated from each other; and
a bonding layer bonding the substrate and the first and second light emitting parts, and including a conductive material.

17. The light emitting device according to claim 16,
wherein the first light emitting part includes a first first-conductivity type semiconductor layer, a first active layer and a first second-conductivity type semiconductor layer,
wherein the second light emitting part includes a second first-conductivity type semiconductor layer, a second active layer and a second second-conductivity type semiconductor layer, and
wherein the third light emitting part includes a third first-conductivity type semiconductor layer, a third active layer and a third second-conductivity type semiconductor layer.

18. The light emitting device according to claim 17, wherein the bonding layer electrically couples the first first-conductivity type semiconductor layer and the second first-conductivity type semiconductor layer.

19. The light emitting device according to claim 18, further comprising:
a first pad electrically coupled with the first second-conductivity type semiconductor layer;
a second pad electrically coupled with the second second-conductivity type semiconductor layer;
a third pad electrically coupled with the third second-conductivity type semiconductor layer; and
a common pad electrically coupled with the bonding layer.

20. The light emitting device according to claim 17,
wherein the bonding layer comprises:
a first bonding layer disposed between the first first-conductivity type semiconductor layer and the substrate; and
a second bonding layer disposed between the second first-conductivity type semiconductor layer and the substrate, and
wherein each of the first and second bonding layers is electrically coupled with the substrate.

21. The light emitting device according to claim 20, further comprising:
a first pad electrically coupled with the first second-conductivity type semiconductor layer;
a second pad electrically coupled with the second second-conductivity type semiconductor layer;
a third pad electrically coupled with the third second-conductivity type semiconductor layer; and
a common pad electrically coupled with the substrate.
